# EUROPEAN PATENT APPLICATION

(11) **EP 4 368 674 A1**
(43) Date of publication of application: **15.05.2024**
(21) Application number: 22837727.1
(22) Date of filing: 07.07.2022
(51) Int. Cl.: C08L 101/00, C08F 222/40, C08J 5/18, H05K 1/03, H05K 3/46

(54) **RESIN COMPOSITION, RESIN FILM, PRINTED WIRING BOARD, AND SEMICONDUCTOR PACKAGE**

(30) Priority: 08.07.2021 WO PCT/JP2021/025766
(71) Applicant: Resonac Corporation, Tokyo 105-7325 (JP)
(72) Inventor: KUZUOKA, Hiroki, Tokyo 100-6606 (JP); KOTAKE, Tomohiko, Tokyo 100-6606 (JP)
(74) Representative: Hoffmann Eitle
(86) International application number: PCT/JP2022/026900
(87) International publication number: WO 2023/282313

(57) **Abstract**

Provided are a resin composition containing (A) a thermosetting resin, (B) a compound that is in a liquid state at 25°C, has a reactive group, and has a molecular weight of 1,000 or less, and (C) an inorganic filler, a resin film using the resin composition, a printed wiring board, and a semiconductor package.

## Description

### Technical Field

The embodiment relates to a resin composition, a resin film, a printed wiring board, and a semiconductor package.

### Background Art

In recent years, miniaturization and high performance of electronics have promoted an increase in wiring density and higher integration in the fields of printed wiring boards and semiconductor packages.

In the electronics, an insulating material such as a thermosetting resin is used as a sealing material for a semiconductor chip, a substrate material of a printed wiring board, and the like. However, there is a problem with stress generated by a difference in thermal expansion coefficient between the insulating material and the semiconductor chip. The generated stress herein causes a warp of a semiconductor package, resulting in a decrease in reliability.

As a method for making the thermal expansion coefficient of the insulating material closer to the thermal expansion coefficient of the semiconductor chip, a method in which an inorganic filler is blended with the insulating material is carried out.

PTL 1 discloses a technology of blending a polybutadiene-based elastomer modified with an acid anhydride in a thermosetting resin composition containing an inorganic filler and a polyimide compound having a structural unit derived from a maleimide resin having at least two N-substituted maleimide groups and a structural unit derived from a diamine compound to provide a thermosetting resin composition having low dielectric loss tangent, low thermal expansibility, excellent wiring-embeddability, and excellent flattening properties.

### Citation List

### Patent Literature

PTL 1: JP 2018-012747 A

### Summary of Invention

### Technical Problem

The thermosetting resin composition in PTL 1 is excellent in dielectric loss tangent, low thermal expansibility, wiring-embeddability, and the like. However, when a resin film having a thickness sufficient to seal a semiconductor chip is formed, the resin film may be cracked during handling. This problem is likely to arise when the thermosetting resin that easily achieves particularly high heat resistance is used or when the inorganic filler that contributes to low thermal expansibility is used. In order to address the aforementioned problem, an improvement in flexibility of a resin composition used for formation of the resin film is considered to be effective. The "flexibility of a resin composition" used herein means flexibility when the resin composition that contains an organic solvent and the like and is in a liquid state is a solid at room temperature (25°C) by drying the organic solvent.

As a method for improving the flexibility of the resin composition in a solid state, a method for holding a small amount of the organic solvent in the resin composition such that a solid is kept is considered. However, when the resin composition containing a small amount of the organic solvent is heated and cured, a void may be generated in a cured product due to the volatilized organic solvent or the surface of the cured product may be roughened. Since the organic solvent is volatilized during heating and curing, creation of a safer work environment is also required. These problems are more significant with an increase in the thickness of the resin film, and therefore improvement is desired.

In view of the circumstances, an object of the embodiment is to provide a resin composition that forms a cured product having favorable low thermal expansibility, has excellent flexibility in a solid state, and can suppress the generation of a volatile component during heating and curing, a resin film using the resin composition, a printed wiring board, and a semiconductor package.

### Solution to Problem

The present inventors have studied to solve the aforementioned problems, and as a result found that the problems can be solved by the following embodiments.

Specifically, the embodiments relate to [1] to [16] below.
[1] A resin composition containing: (A) a thermosetting resin; (B) a compound that is in a liquid state at 25°C, has a reactive group, and has a molecular weight of 1,000 or less; and (C) an inorganic filler.
[2] The resin composition according to [1], in which the component (A) is one or more selected from the group consisting of a maleimide resin having one or more N-substituted maleimide groups and a derivative of the maleimide resin.
[3] The resin composition according to [2], in which the maleimide resin having one or more N-substituted maleimide groups is a maleimide resin containing a condensed ring of an aromatic ring and an aliphatic ring in a molecular structure and having two or more N-substituted maleimide groups.
[4] The resin composition according to any one of [1] to [3], in which the component (B) has as the reactive group one or more groups selected from a vinyl group, an allyl group, a maleimide group, a (meth)acryloyl group, an epoxy group, a hydroxy group, a carboxy group, and an amino group.
[5] The resin composition according to any one of [1] to [4], in which the number of the reactive group in the component (B) is two or more in one molecule.
[6] The resin composition according to any one of [1] to [5], in which the component (B) is a di(meth)acrylate.
[7] The resin composition according to any one of [1] to [6], in which the content of the component (B) relative to the total amount (100 mass%) of the components (A), (B), and (C) is 1 to 20 mass%.
[8] The resin composition according to any one of [1] to [7], further containing (D) an elastomer having a molecular weight of more than 1,000.
[9] The resin composition according to any one of [1] to [8], the resin composition being used for formation of a resin film having a thickness of 80 µm or more.
[10] A resin film including the resin composition according to any one of [1] to [8].
[11] The resin film according to [10], the resin film having a thickness of 80 µm or more.
[12] The resin film according to [10], in which the resin film has a thickness of 150 µm or more, and a cured product of the resin film has a relative dielectric constant (Dk) at 10 GHz of less than 2.8 and a dielectric loss tangent (Df) of less than 0.0030.
[13] The resin film according to any one of [10] to [12], in which a mass reduction rate during heating and drying at 170°C for 30 minutes in an air atmosphere is 2.0 mass% or less.
[14] A printed wiring board including a cured product of the resin film according to any one of [10] to [13].
[15] A semiconductor package including a cured product of the resin film according to any one of [10] to [13].
[16] The semiconductor package according to [15], including a semiconductor chip sealed with the cured product of the resin film.

### Advantageous Effects of Invention

The embodiment can provide a resin composition that forms a cured product having favorable low thermal expansibility, has excellent flexibility in a solid state, and can suppress the generation of a volatile component during heating and curing, a resin film using the resin composition, a printed wiring board, and a semiconductor package.

### Description of Embodiments

As used herein, the numerical value range indicated by using "to" represents a range including the numerical values indicated before and after "to" as the minimum value and the maximum value, respectively.

For example, the expression of the numerical value range of "X to Y" (X and Y are real numbers) means the numerical value range of X or more and Y or less. As used herein, "X or more" means X and a numerical value more than X. As used herein, "Y or less" means Y and a numerical value less than Y

The lower limit value and the upper limit value of a numerical value range described herein are each optionally combined with the lower limit value or the upper limit value of another numerical value range.

In the numerical value range described herein, the lower limit value or the upper limit value of the numerical value range may be replaced by a value shown in Examples.

Unless otherwise specified, one type of component and material exemplified herein may be used alone, or two or more types thereof may be used in combination.

As used herein, if a plurality of substances corresponding to a component in a resin composition are present, the content of the component in the resin composition means the total amount of the substances present in the resin composition unless otherwise specified.

The "resin composition" herein means a mixture of two or more components containing at least a resin. When the resin is a thermosetting resin, the resin composition contains the mixture in a B-stage state. Herein, the type and content of the component in the resin composition in a B-stage state means the type and content of the component before the B-stage state, that is, the type and blending amount of the component blended during production of the resin composition.

As used herein, a "solid content" means a component except for a solvent and includes a liquid state, a viscous state like starch syrup, and a wax state at room temperature. The room temperature used herein indicates 25°C.

A "(meth)acrylate" used herein means "acrylate" and "methacrylate" corresponding to the acrylate. Similarly, "(meth)acryl" means "acryl" and "methacryl" corresponding to the acryl, and "(meth)acryloyl" means "acryloyl" and "methacryloyl" corresponding to the acryloyl.

As used herein, the "molecular weight" of a compound that is not a polymer and has a specified structural formula means the molecular weight that can be calculated from the structural formula, and the "molecular weight" of a compound that is a polymer means a number average molecular weight.

As used herein, the number average molecular weight means a value determined in terms of polystyrene by gel permeation chromatography (GPC). Specifically, the number average molecular weight used herein can determined by a method described in Examples.

An action mechanism described herein is conjecture, and does not limit a mechanism that achieves the effect of a resin composition according to the embodiment.

The embodiment also includes aspects in which items described herein are optionally combined.

### [Resin Composition]

The resin composition of the embodiment is a resin composition containing (A) a thermosetting resin, (B) a compound that is in a liquid state at 25°C, has a reactive group, and has a molecular weight of 1,000 or less, and (C) an inorganic filler.

In the following description, the thermosetting resin (A) may be referred to as "component (A)".

The compound (B) that is in a liquid state at 25°C, has a reactive group, and has a molecular weight of 1,000 or less may be referred to as "reactive liquid compound (B)" or "component (B)".

The inorganic filler (C) may be referred to as "component (C)".

In the embodiment, a liquid state at 25°C means that the viscosity determined by the following measurement method is 100,000 mPa s or less.

### <Method for Measuring Viscosity>

Device: E-type viscometer
Cone rotor: 1°34' × R24
Temperature: 25°C
Sample amount: 1.0 mL
Rotation speed: 20 rpm

In the present description, the viscosity at 25°C means the viscosity measured by the aforementioned method.

The reason why the resin composition of the embodiment forms a cured product having favorable low thermal expansibility, has excellent flexibility in a solid state, and can suppress the generation of a volatile component during heating and curing is presumed as follows.

The resin composition of the embodiment contains as a component of improving the flexibility of the resin composition the compound (B) that is in a liquid state at 25°C and has a molecular weight of 1,000 or less. Since the reactive liquid compound (B) is a liquid component having a relatively low molecular weight, it is considered that the compound can favorably enter a space between molecules of the resin component and effectively decrease the interaction between the molecules of the resin component, to improve the flexibility of the resin composition.

Since the reactive liquid compound (B) has a reactive group, the reactive liquid compound (B) can be reacted with the reactive liquid compound (B) or another component during heating and curing of the thermosetting resin (A). That is, while the reactive liquid compound (B) contributes to the improvement in flexibility, a curing reaction suppresses volatilization. Therefore, it is considered that the resin composition of the embodiment can improve flexibility while the generation of a volatile component is suppressed, as compared with a case where an organic solvent and the like are used as a component of improving flexibility.

Each component that can be contained in the resin composition of the embodiment will be described below in turn.

### <(A) Thermosetting Resin>

The resin composition of the embodiment contains the thermosetting resin (A).

One type of the thermosetting resin (A) may be used alone, or two or more types thereof may be used in combination.

Examples of the thermosetting resin (A) include an epoxy resin, a phenol resin, a maleimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin.

Among them, from the viewpoint of heat resistance, the thermosetting resin (A) is preferably a maleimide resin, and more preferably one or more selected from the group consisting of a maleimide resin having one or more N-substituted maleimide groups and a derivative of the maleimide resin.

In the following description, the "one or more selected from the group consisting of a maleimide resin having one or more N-substituted maleimide groups and a derivative of the maleimide resin" may be referred to as "maleimide-based resin".

In the following description, the maleimide resin having one or more N-substituted maleimide groups may be referred to as "maleimide resin (AX)" or "component (AX)".

In the following description, the derivative of the maleimide resin having one or more N-substituted maleimide groups may be referred to as "maleimide resin derivative (AY)" or "component (AY)".

### (Maleimide Resin (AX))

The maleimide resin (AX) is not particularly limited as long as it is a maleimide resin having one or more N-substituted maleimide groups.

From the viewpoint of conductor adhesive properties and heat resistance, the maleimide resin (AX) is preferably an aromatic maleimide resin having two or more N-substituted maleimide groups, and more preferably an aromatic bismaleimide resin having two N-substituted maleimide groups.

The "aromatic maleimide resin" used herein means a compound having a N-substituted maleimide group that is directly bonded to an aromatic ring. The "aromatic bismaleimide resin" used herein means a compound having two N-substituted maleimide groups that are directly bonded to an aromatic ring. An "aromatic polymaleimide resin" used herein means a compound having three or more N-substituted maleimide groups that are directly bonded to an aromatic ring.

An "aliphatic maleimide resin" used herein means a compound having a N-substituted maleimide group that is directly bonded to an aliphatic hydrocarbon.

From the viewpoint of dielectric properties, conductor adhesive properties, and heat resistance, the maleimide resin (AX) is preferably a maleimide resin containing a condensed ring of an aromatic ring and an aliphatic ring in a molecular structure and having two or more N-substituted maleimide groups (hereinafter sometimes referred to as "maleimide resin (A1)" or "component (A1)").

### [Maleimide Resin (A1)]

From the viewpoint of dielectric properties, conductor adhesive properties, and heat resistance, the maleimide resin (A1) is preferably an aromatic maleimide resin containing a condensed ring of an aromatic ring and an aliphatic ring in a molecular structure and having two or more N-substituted maleimide groups.

The maleimide resin (A1) is more preferably an aromatic bismaleimide resin containing a condensed ring of an aromatic ring and an aliphatic ring in a molecular structure and having two N-substituted maleimide groups.

From the viewpoint of dielectric properties, conductor adhesive properties, and production easiness, the condensed ring in the maleimide resin (A1) is preferably a ring having a condensed bicyclic structure, and more preferably an indan ring.

The maleimide resin (A1) containing an indan ring is preferably an aromatic bismaleimide resin containing an indan ring.

The indan ring used herein means a condensed bicyclic structure of an aromatic six-membered ring and a saturated aliphatic five-membered ring. At least one carbon atom among ring-forming carbon atoms that form an indan ring has a binding group for binding to another group constituting the maleimide resin (A1). A ring-forming carbon atom having the binding group and other ring-forming carbon atom may not have a binding group, a substituent, and the like, in addition to the aforementioned binding group. It is preferable that the ring-forming carbon atom having the binding group and the other ring-forming carbon atom form a divalent group with a binding group other than the aforementioned binding groups.

It is preferable that the maleimide resin (A1) contains the indan ring as a divalent group represented by the following general formula (A1-1). 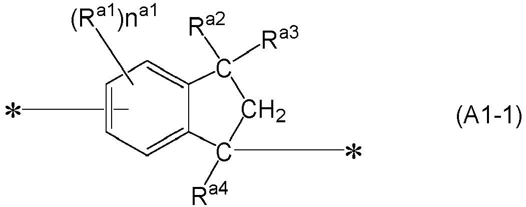 (In the formula, R^{a1} is an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a hydroxy group, or a mercapto group, n^{a1} is an integer of 0 to 3, R^{a2} to R^{a4} are each independently an alkyl group having 1 to 10 carbon atoms, and * represents a binding moiety.)

Examples of the alkyl group having 1 to 10 carbon atoms represented by R^{a1} in the general formula (A1-1) include a methyl group, an ethyl group, a propyl group, a butyl group, a pentyl group, a hexyl group, a heptyl group, an octyl group, a nonyl group, and a decyl group. The alkyl groups may be linear or branched.

Examples of the alkyl group contained in the alkyloxy group having 1 to 10 carbon atoms and the alkylthio group having 1 to 10 carbon atoms represented by R^{a1} include those exemplified as the alkyl group having 1 to 10 carbon atoms.

Examples of the aryl group having from 6 to 10 carbon atoms represented by R^{a1} include a phenyl group and a naphthyl group.

Examples of the aryl group contained in the aryloxy group having 6 to 10 carbon atoms and the arylthio group having 6 to 10 carbon atoms represented by R^{a1} include those exemplified as the aryl group having 6 to 10 carbon atoms.

Examples of the cycloalkyl group having 3 to 10 carbon atoms represented by R^{a1} include a cyclopropyl group, a cyclobutyl group, a cyclopentyl group, a cyclohexyl group, a cycloheptyl group, a cyclooctyl group, a cyclononyl group, and a cyclodecyl group.
when n^{a1} in the general formula (A1-1) is an integer of 1 to 3, from the viewpoint of solvent solubility and reactivity, R^{a1} is preferably an alkyl group having 1 to 4 carbon atoms, a cycloalkyl group having 3 to 6 carbon atoms, or an aryl group having 6 to 10 carbon atoms, and more preferably an alkyl group having 1 to 4 carbon atoms.

Examples of the alkyl group having 1 to 10 carbon atoms represented by R^{a2} to R^{a4} include a methyl group, an ethyl group, a propyl group, a butyl group, a pentyl group, a hexyl group, a heptyl group, an octyl group, a nonyl group, and a decyl group. The alkyl groups may be linear or branched. Among them, R^{a2} to R^{a4} are preferably an alkyl group having 1 to 4 carbon atoms, more preferably a methyl group or an ethyl group, and further preferably a methyl group.

In the general formula (A1-1), n^{a1} is an integer of 0 to 3. When n^{a1} is 2 or 3, a plurality of R^{a1}'s may be the same as or different from each other.

Above all, from the viewpoint of production easiness, the divalent group represented by the general formula (A1-1) is preferably a divalent group represented by the following general formula (A1-1a) in which n^{a1} is 0 and R^{a2} to R^{a4} are a methyl group, and more preferably a divalent group represented by the following general formula (A1-1a') or a divalent group represented by the following general formula (A1-1a"). 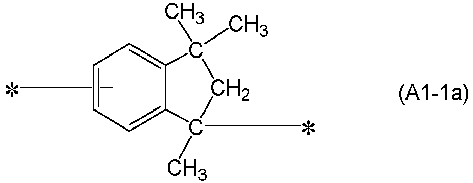 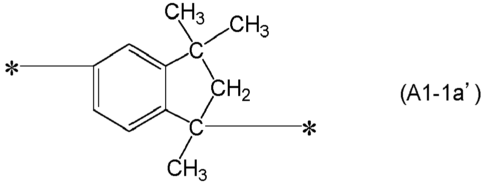 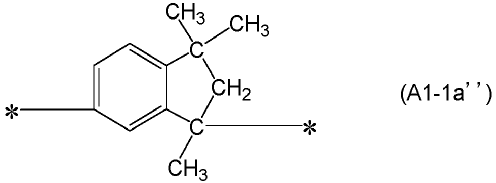 (In the formulae * represents a binding moiety.)

From the viewpoint of dielectric properties, conductor adhesive properties, heat resistance, and production easiness, the maleimide resin (A1) containing the divalent group represented by the general formula (A1-1) is preferably one represented by the following general formula (A1-2). 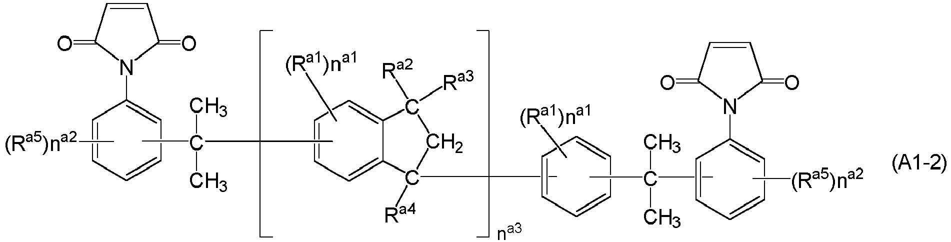 (In the formula, R^{a1} to R^{a4} and n^{a1} are the same as those in the general formula (A1-1), R^{a5}'s are each independently an alkyl group having 1 to 10 carbon atoms, an alkyloxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a nitro group, a hydroxy group, or a mercapto group, n^{a2}'s are each independently an integer of 0 to 4, and n^{a3} is a number of 0.95 to 10.0.)

In the general formula (A1-2), a plurality of R^{a1}'s, a plurality of n^{a1}'s, a plurality of R^{a5}'s, and a plurality of n^{a2}'s may be the same as or different from each other.

When n^{a3} is more than 1, a plurality of R^{a2}'s, a plurality of R^{a3}'s, and a plurality of R^{a4}'s may be the same as or different from each other.

Examples of the alkyl group having 1 to 10 carbon atoms represented by R^{a5} in the general formula (A1-2) include a methyl group, an ethyl group, a propyl group, a butyl group, a pentyl group, a hexyl group, a heptyl group, an octyl group, a nonyl group, and a decyl group. The alkyl groups may be linear or branched.

Examples of the alkyl group contained in the alkyloxy group having 1 to 10 carbon atoms and the alkylthio group having 1 to 10 carbon atoms represented by R^{a5} include those exemplified as the alkyl group having 1 to 10 carbon atoms.

Examples of the aryl group having 6 to 10 carbon atoms represented by R^{a5} include a phenyl group and a naphthyl group.

Examples of the aryl group contained in the aryloxy group having 6 to 10 carbon atoms and the arylthio group having 6 to 10 carbon atoms represented by R^{a5} include those exemplified as the aryl group having 6 to 10 carbon atoms.

Examples of the cycloalkyl group having 3 to 10 carbon atoms represented by R^{a5} include a cyclopropyl group, a cyclobutyl group, a cyclopentyl group, a cyclohexyl group, a cycloheptyl group, a cyclooctyl group, a cyclononyl group, and a cyclodecyl group.

Among them, from the viewpoint of solvent solubility and production easiness, R^{a5} is preferably an alkyl group having 1 to 4 carbon atoms, a cycloalkyl group having 3 to 6 carbon atoms, or an aryl group having 6 to 10 carbon atoms, more preferably an alkyl group having 1 to 3 carbon atoms, and further preferably a methyl group.

In the general formula (A1-2), n^{a2} is an integer of 0 to 4. From the viewpoint of compatibility with other resin, dielectric properties, conductor adhesive properties, and production easiness, n^{a2} is preferably an integer of 1 to 3, more preferably 2 or 3, and further preferably 2.

When n^{a2} is 1 or more, a benzene ring and a N-substituted maleimide group form a staggered conformation, and solvent solubility tends to be improved by suppression of intermolecular stacking. When n^{a2} is 1 or more, a site of substitution of R^{a5} is preferably an ortho position with respect to the N-substituted maleimide group from the viewpoint of the suppression of intermolecular stacking.

From the viewpoint of dielectric properties, conductor adhesive properties, solvent solubility, handling properties, and heat resistance, n^{a3} in the general formula (A1-2) is preferably a number of 0.98 to 8.0, more preferably a number of 1.0 to 7.0, and further preferably a number of 1.1 to 6.0. n^{a3} represents the average value for the number of structural unit containing an indan ring.

From the viewpoint of dielectric properties, conductor adhesive properties, solvent solubility, and production easiness, the maleimide resin (A1) represented by the general formula (A1-2) is preferably one represented by the following general formula (A1-3), and more preferably one represented by the following general formula (A1-4). 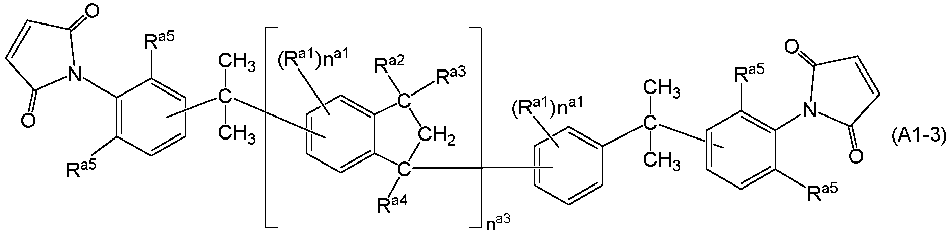 (In the formula, R^{a1} to R^{a5} and n^{a1} and n^{a3} are the same as those in the general formula (A1-2).)

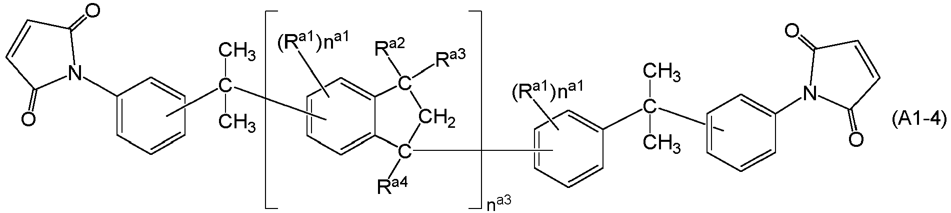

(In the formula, R^{a1} to R^{a4} and n^{a1} and n^{a3} are the same as those in the general formula (A1-2).)

Examples of the maleimide resin (A1) represented by the general formula (A1-3) include a maleimide resin represented by the following general formula (A1-3-1), a maleimide resin represented by the following general formula (A1-3-2), and a maleimide resin represented by the following general formula (A1-3-3). 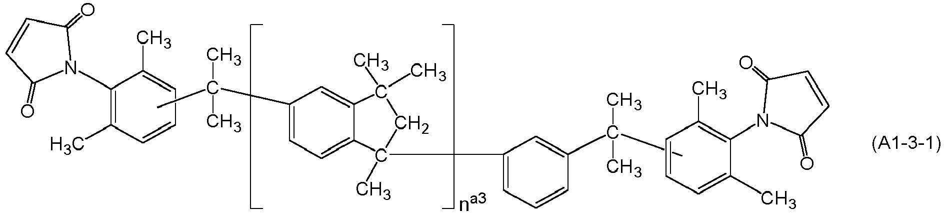 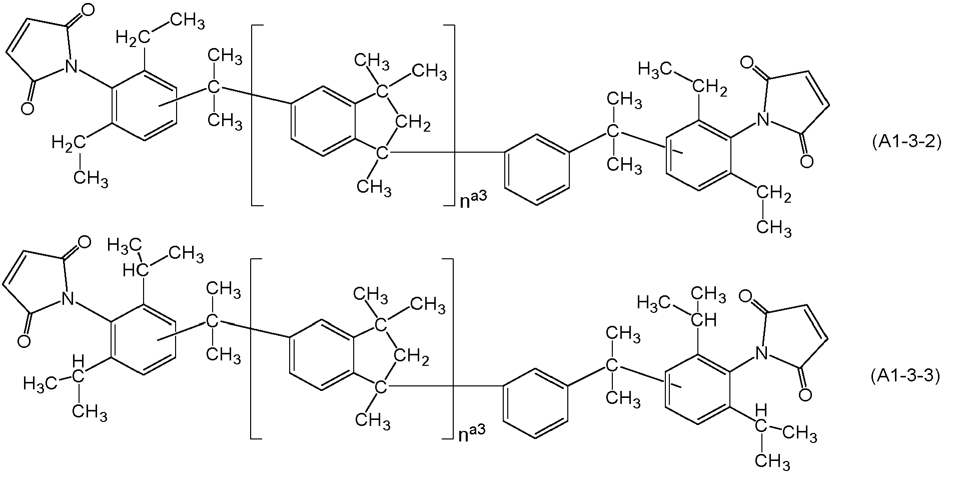 (In the formulae, n^{a3} is the same as those in the general formula (A1-2).)

From the viewpoint of dielectric properties, conductor adhesive properties, solvent solubility, and production easiness, the maleimide resin (A1) represented by the general formula (A1-4) is more preferably one represented by the following general formula (A1-4-1). 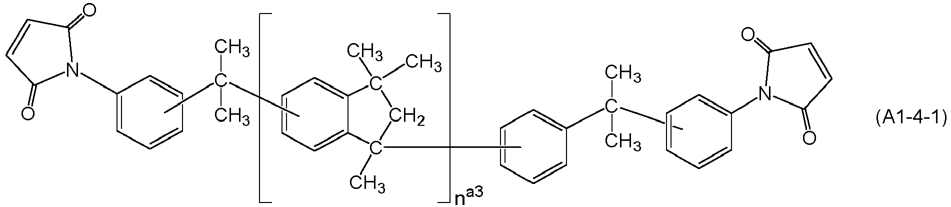 (In the formula, n^{a3} is the same as those in the general formula (A1-2).)

The number average molecular weight of the maleimide resin (A1) is not particularly limited, and from the viewpoint of compatibility with the other resin, conductor adhesive properties, and heat resistance, it is preferably 600 to 3,000, more preferably 800 to 2,000, and further preferably 1,000 to 1,500.

For example, the maleimide resin (A1) can be produced by a method for reacting an intermediate amine compound containing a condensed ring of an aromatic ring and an aliphatic ring (hereinafter similarly abbreviated as "intermediate amine compound") with maleic anhydride (hereinafter sometimes referred to as "a maleimide group-forming reaction").

Hereinafter, a method for producing the maleimide resin (A1) will be described using as an example a maleimide resin containing an indan ring as a condensed ring of an aromatic ring and an aliphatic ring.

An intermediate amine compound of the maleimide resin containing an indan ring can be obtained, for example, as a compound represented by the following general formula (A1-7) by reacting a compound represented by the following general formula (A1-5) (hereinafter sometimes referred to as "compound A") with a compound represented by the following general formula (A1-6) (hereinafter sometimes referred to as "compound B") in the presence of an acid catalyst (hereinafter sometimes referred to as "cyclization reaction"). 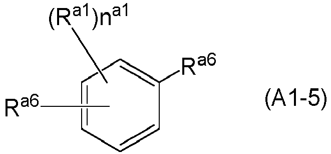 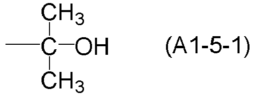 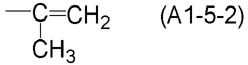 (In the formulae, R^{a1} and n^{a1} are the same as those in the general formula (A1-1), R^{a6}'s are each independently a group represented by the general formula (A1-5-1) or (A1-5-2), and a group in an ortho position with respect to at least one of the two R^{a6}'s is a hydrogen atom.) 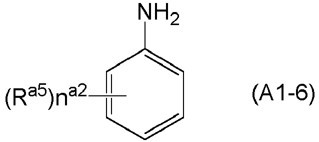 (In the formula, R^{a5} and n^{a2} are the same as those in the general formula (A1-2). Provided that a group in at least one of an ortho position and a para position with respect to the amino group is a hydrogen atom.) 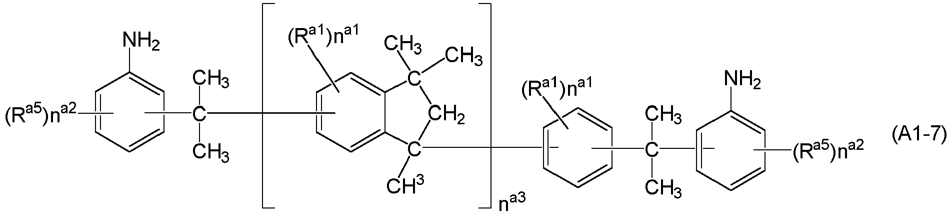 (In the formula, R^{a1}, R^{a5}, and n^{a1} to n^{a3} are the same as those in the general formula (A1-2).)

Examples of the compound A include p- or m-diisopropenylbenzene, p- or m-bis(a-hydroxyisopropyl)benzene, 1-(α-hydroxyisopropyl)-3-isopropenylbenzene, 1-(α-hydroxyisopropyl)-4-isopropenylbenzene, a mixture thereof, a nuclear alkyl group-substituted product of the compounds, and a nuclear halogen-substituted product of the compounds.

Examples of the nuclear alkyl group-substituted product include diisopropenyltoluene and bis(α-hydroxyisopropyl)toluene.

Examples of the nuclear halogen-substituted product include chlorodiisopropenylbenzene and chlorobis(α-hydroxyisopropyl)benzene.

One type of the compound A may be used alone, or two or more types thereof may be used in combination.

Examples of the compound B include aniline, dimethylaniline, diethylaniline, diisopropylaniline, ethylmethylaniline, cyclobutylaniline, cyclopentylaniline, cyclohexylaniline, chloroaniline, dichloroaniline, toluidine, xylidine, phenylaniline, nitroaniline, aminophenol, methoxyaniline, ethoxyaniline, phenoxyaniline, naphthoxyaniline, aminothiol, methylthioaniline, ethylthioaniline, and phenylthioaniline. One type of the compound B may be used alone, or two or more types thereof may be used in combination.

In the cyclization reaction, for example, the compounds A and B are prepared at a molar ratio thereof (compound B/compound A) of preferably 0.1 to 2.0, more preferably 0.15 to 1.5, and further preferably 0.2 to 1.0 and subjected to a first reaction.

It is preferable that the compound B be added such that the molar ratio of the additional compound B to the compound A which had been added (additional compound B/compound A) is preferably 0.5 to 20, more preferably 0.6 to 10, and further preferably 0.7 to 5 and a second reaction be carried out.

Examples of the acid catalyst used in the cyclization reaction include inorganic acids such as phosphoric acid, hydrochloric acid, and sulfuric acid; organic acids such as oxalic acid, benzenesulfonic acid, toluenesulfonic acid, methanesulfonic acid, and fluoromethanesulfonic acid; solid acids such as activated clay, acid clay, silica alumina, zeolite, and a strong acidic ion exchange resin; and heteropolyhydrochloric acid. One type of the acid catalyst may be used alone, or two or more types thereof may be used in combination.

From the viewpoint of reaction rate and reaction uniformity, the amount of the acid catalyst blended is preferably 5 to 40 parts by mass, more preferably 5 to 35 parts by mass, and further preferably 5 to 30 parts by mass, relative to 100 parts by mass of the total amount of the compound A and the compound B prepared at first.

From the viewpoint of reaction rate and reaction uniformity, the reaction temperature of the cyclization reaction is preferably 100 to 300°C, more preferably 130 to 250°C, and further preferably 150 to 230°C.

From the viewpoint of productivity and sufficient promotion of the reaction, the reaction time of the cyclization reaction is preferably 2 to 24 hours, more preferably 4 to 16 hours, and further preferably 8 to 12 hours.

These reaction conditions can be appropriately adjusted depending on the types of used raw materials, and the like, and are not particularly limited.

In the cyclization reaction, a solvent such as toluene, xylene, or chlorobenzene may be used, if necessary. When water is produced as a by-product in the cyclization reaction, a solvent capable of azeotropic dehydration may be used to promote a dehydration reaction.

Next, the intermediate amine compound is reacted with maleic anhydride in the organic solvent. Thus, a maleimide group-forming reaction in which a primary amino group of the intermediate amine compound is converted into a maleimide group is carried out. By this maleimide group-forming reaction, the maleimide resin (A1) can be obtained.

The ratio (maleic anhydride/primary amino group) of the equivalent weight of maleic anhydride to the equivalent weight of the primary amino group of the intermediate amine compound in the maleimide group-forming reaction is not particularly limited, and from the viewpoint of decreasing the amount of unreacted primary amino group and the amount of unreacted maleic anhydride, it is preferably 1.0 to 1.5, more preferably 1.05 to 1.3, and further preferably 1.1 to 1.2.

The amount of the organic solvent used in the maleimide group-forming reaction is not particularly limited, and from the viewpoint of reaction rate and reaction uniformity, it is preferably 50 to 5,000 parts by mass, more preferably 70 to 2,000 parts by mass, and further preferably 100 to 500 parts by mass, relative to 100 parts by mass of the total amount of the intermediate amine compound and maleic anhydride.

In the maleimide group-forming reaction, it is preferable that the intermediate amine compound and maleic anhydride be subjected to a two-step reaction.

The reaction temperature in a first reaction is preferably 10 to 100°C, more preferably 20 to 70°C, and further preferably 30 to 50°C.

The reaction time in the first reaction is preferably 0.5 to 12 hours, more preferably 0.7 to 8 hours, and further preferably 1 to 4 hours.

It is preferable that the after completion of the first reaction, a second reaction be performed by adding a catalyst such as toluenesulfonic acid.

The reaction temperature in the second reaction is preferably 90 to 130°C, more preferably 100 to 125°C, and further preferably 105 to 120°C.

The reaction time in the second reaction is preferably 2 to 24 hours, more preferably 4 to 15 hours, and further preferably 6 to 10 hours.

These reaction conditions can be appropriately adjusted depending on the types of used raw materials, and the like, and are not particularly limited.

After the reaction, unreacted raw materials, other impurities, and the like may be removed by purification such as water-washing, if necessary.

The maleimide resin (A1) obtained by the aforementioned method may contain a maleimide resin containing no indan ring as a by-product. The maleimide resin containing no indan ring is, for example, a compound represented by the general formula (A1-2) in which n^{a3} is 0.

The content of the maleimide resin containing no indan ring that is a by-product in the reaction product can be determined, for example, by measurement of GPC of the reaction product. Specifically, the calibration curve of elution time relative to the number of n^{a3} is created using each of the compounds represented by the general formula (A1-2) in which n^{a3} is 0 to 4, and from the elution times of peaks found in a GPC chart of the reaction product, the number of n^{a3} in a compound contained in the reaction product and the average value thereof can be found. From the area ratio of each of the peaks, the content proportion of a compound in which the number of n^{a3} represents the corresponding peak can be found.

In the maleimide resin (A1), it is preferable that the content of the maleimide resin containing no indan ring as a by-product be low. Therefore, the proportion of the area of the maleimide resin containing no indan ring as a by-product relative to the peak area of the whole of the reaction product in the GPC chart of the reaction product is preferably 40% or less, more preferably 30% or less, further preferably 20% or less, and particularly preferably 10% or less.

The maleimide resin (AX) may be a maleimide resin (A2) other than the maleimide resin (A1) (hereinafter sometimes referred to as "maleimide resin (A2)" or "component (A2)".

### [Maleimide Resin (A2)]

The maleimide resin (A2) is preferably a maleimide resin represented by the following general formula (A2-1). 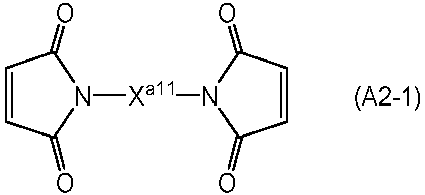 (In the formula, X^{a11} is a divalent organic group containing no condensed ring of an aromatic ring and an aliphatic ring.)

X^{a11} in the general formula (A2-1) is a divalent organic group containing no condensed ring of an aromatic ring and an aliphatic ring.

Examples of the divalent organic group represented by X^{a11} in the general formula (A2-1) include a divalent group represented by the following general formula (A2-2), a divalent group represented by the following general formula (A2-3), a divalent group represented by the following general formula (A2-4), a divalent group represented by the following general formula (A2-5), and a divalent group represented by the following general formula (A2-6). 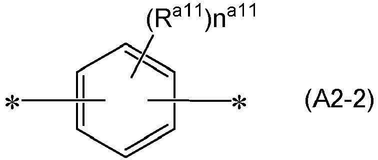 (In the formula, R^{a11} is an aliphatic hydrocarbon group having 1 to 5 carbon atoms or a halogen atom, n^{a11} is an integer of 0 to 4, and * represents a binding moiety.)

Examples of the aliphatic hydrocarbon group having 1 to 5 carbon atoms represented by R^{a11} in the general formula (A2-2) include alkyl groups having 1 to 5 carbon atoms such as a methyl group, an ethyl group, an n-propyl group, an isopropyl group, an n-butyl group, an isobutyl group, a t-butyl group, and an n-pentyl group; an alkenyl group having 2 to 5 carbon atoms, and an alkynyl group having 2 to 5 carbon atoms. The aliphatic hydrocarbon group having 1 to 5 carbon atoms may be linear or branched. The aliphatic hydrocarbon group having 1 to 5 carbon atoms is preferably an aliphatic hydrocarbon group having 1 to 3 carbon atoms, more preferably an alkyl group having 1 to 3 carbon atoms, and further preferably a methyl group.

Examples of the halogen atom include a fluorine atom, a chlorine atom, a bromine atom, and an iodine atom.

In the general formula (A2-2), n^{a11} is an integer of 0 to 4. From the viewpoint of availability, n^{a11} is preferably an integer of 0 to 2, more preferably 0 or 1, and further preferably 0.

When n^{a11} is an integer of 2 or more, a plurality of R^{a11}'s may be the same as or different from each other. 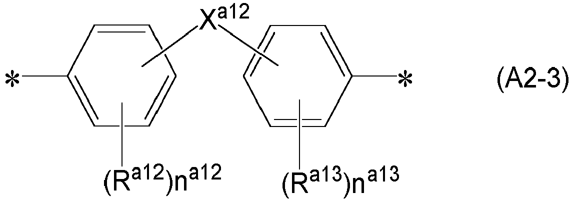 (In the formula, R^{a12} and R^{a13} are each independently an aliphatic hydrocarbon group having 1 to 5 carbon atoms or a halogen atom, X^{a12} is an alkylene group having 1 to 5 carbon atoms, an alkylidene group having 2 to 5 carbon atoms, an ether group, a sulfide group, a sulfonyl group, a carbonyloxy group, a keto group, a single bond, or a divalent group represented by the following general formula (A2-3-1), n^{a12} and n^{a13} are each independently an integer of 0 to 4, and * represents a binding moiety.)

Examples of the aliphatic hydrocarbon group having 1 to 5 carbon atoms represented by R^{a12} and R^{a13} in the general formula (A2-3) include alkyl groups having 1 to 5 carbon atoms such as a methyl group, an ethyl group, an n-propyl group, an isopropyl group, an n-butyl group, an isobutyl group, a t-butyl group, and an n-pentyl group; an alkenyl group having 2 to 5 carbon atoms, and an alkynyl group having 2 to 5 carbon atoms. The aliphatic hydrocarbon group having 1 to 5 carbon atoms may be linear or branched. From the viewpoint of compatibility with the other resin and suppression of gelation of a product in a reaction, the aliphatic hydrocarbon group having 1 to 5 carbon atoms is preferably an aliphatic hydrocarbon group having 1 to 3 carbon atoms, more preferably an alkyl group having 1 to 3 carbon atoms, and further preferably a methyl group or an ethyl group.

Examples of the halogen atom include a fluorine atom, a chlorine atom, a bromine atom, and an iodine atom.

Examples of the alkylene group having 1 to 5 carbon atoms represented by X^{a12} in the general formula (A2-3) include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and further preferably a methylene group.

Examples of the alkylidene group having 2 to 5 carbon atoms represented by X^{a12} in the general formula (A2-3) include an ethylidene group, a propylidene group, an isopropylidene group, a butylidene group, an isobutylidene group, a pentylidene group, and an isopentylidene group. Among them, an alkylidene group having 2 to 4 carbon atoms is preferred, an alkylidene group having 2 or 3 carbon atoms is more preferred, and an isopropylidene group is further preferred.

In the general formula (A2-3), n^{a12} and n^{a13} are each independently an integer of 0 to 4. From the viewpoint of availability, compatibility with other resin, and suppression of gelation of the product in the reaction, n^{a12} and n^{a13} are preferably an integer of 1 to 3, more preferably 1 or 2, and further preferably 2.

From the viewpoint of availability, compatibility with other resin, and suppression of gelation of the product in the reaction, n^{a12} + n^{a13} is preferably an integer of 1 to 8, more preferably an integer of 2 to 6, and further preferably 4.

When n^{a12} or n^{a13} is an integer of 2 or more, a plurality of R^{a12}'s or a plurality of R^{a13}'s may be the same as or different from each other.

The divalent group represented by the general formula (A2-3-1) as X^{a12} in the general formula (A2-3) is as follows. 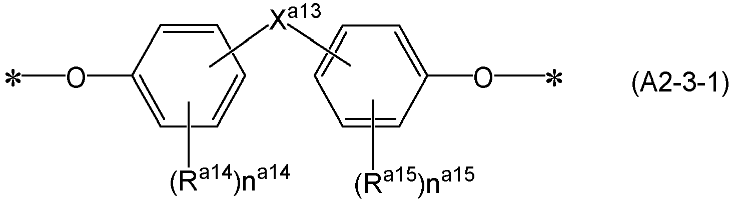 (In the formula, R^{a14} and R^{a15} are each independently an aliphatic hydrocarbon group having 1 to 5 carbon atoms or a halogen atom, X^{a13} is an alkylene group having 1 to 5 carbon atoms, an alkylidene group having 2 to 5 carbon atoms, an ether group, a sulfide group, a sulfonyl group, a carbonyloxy group, a keto group, or a single bond, n^{a14} and n^{a15} are each independently an integer of 0 to 4, and * represents a binding moiety.)

Examples of the aliphatic hydrocarbon group having 1 to 5 carbon atoms represented by R^{a14} and R^{a15} in the general formula (A2-3-1) include alkyl groups having 1 to 5 carbon atoms such as a methyl group, an ethyl group, an n-propyl group, an isopropyl group, an n-butyl group, an isobutyl group, a t-butyl group, and an n-pentyl group; an alkenyl group having 2 to 5 carbon atoms, and an alkynyl group having 2 to 5 carbon atoms. The aliphatic hydrocarbon group having 1 to 5 carbon atoms may be linear or branched. The aliphatic hydrocarbon group having 1 to 5 carbon atoms is preferably an aliphatic hydrocarbon group having 1 to 3 carbon atoms, more preferably an alkyl group having 1 to 3 carbon atoms, and further preferably a methyl group.

Examples of the halogen atom include a fluorine atom, a chlorine atom, a bromine atom, and an iodine atom.

Examples of the alkylene group having 1 to 5 carbon atoms represented by X^{a13} in the general formula (A2-3-1) include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and further preferably a methylene group.

Examples of the alkylidene having 2 to 5 carbon atoms represented by X^{a13} in the general formula (A2-3-1) include an ethylidene group, a propylidene group, an isopropylidene group, a butylidene group, an isobutylidene group, a pentylidene group, and an isopentylidene group. Among them, an alkylidene group having 2 to 4 carbon atoms is preferred, an alkylidene group having 2 or 3 carbon atoms is more preferred, and an isopropylidene group is further preferred.

Among the options, the X^{a13} in the general formula (A2-3-1) is preferably an alkylidene group having 2 to 5 carbon atoms, more preferably an alkylidene group having 2 to 4 carbon atoms, and further preferably an isopropylidene group.

In the general formula (A2-3-1), n^{a14} and n^{a15} are each independently an integer of 0 to 4. From the viewpoint of availability, n^{a14} and n^{a15} are preferably an integer of 0 to 2, more preferably 0 or 1, and further preferably 0.

When n^{a14} or n^{a15} is an integer of 2 or more, a plurality of R^{a14}'s or a plurality of R^{a15}'s may be the same as or different from each other.

Among the options, the X^{a12} in the general formula (A2-3) is preferably an alkylene group having 1 to 5 carbon atoms, an alkylidene group having 2 to 5 carbon atoms, or the divalent group represented by the general formula (A2-3-1), more preferably an alkylene group having 1 to 5 carbon atoms, and further preferably a methylene group. 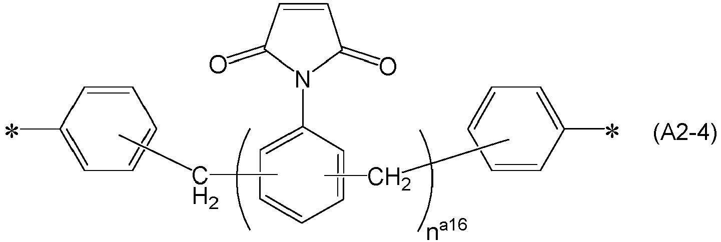 (In the formula, n^{a16} is an integer of 0 to 10 and * represents a binding moiety.)

From the viewpoint of availability, n^{a16} in the general formula (A2-4) is preferably an integer of 0 to 5, more preferably an integer of 0 to 4, and further preferably an integer of 0 to 3. 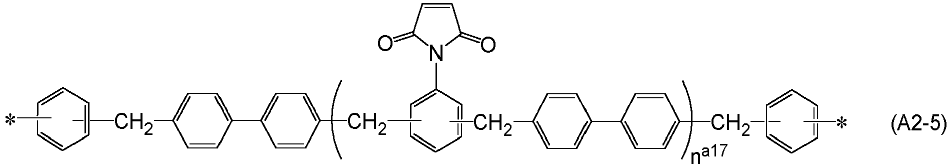 (In the formula, n^{a17} is a number of 0 to 5 and * represents a binding moiety.) 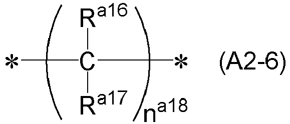 (In the formula, R^{a16} and R^{a17} are each independently a hydrogen atom or an aliphatic hydrocarbon group having 1 to 5 carbon atoms, n^{a18} is an integer of 1 to 8, and * represents a binding moiety.)

Examples of the aliphatic hydrocarbon group having 1 to 5 carbon atoms represented by R^{a16} and R^{a17} in the general formula (A2-6) include alkyl groups having 1 to 5 carbon atoms such as a methyl group, an ethyl group, an n-propyl group, an isopropyl group, an n-butyl group, an isobutyl group, a t-butyl group, and an n-pentyl group; an alkenyl group having 2 to 5 carbon atoms, and an alkynyl group having 2 to 5 carbon atoms. The aliphatic hydrocarbon group having 1 to 5 carbon atoms may be linear or branched.

n^{a18} in the general formula (A2-6) is an integer of 1 to 8, preferably an integer of 1 to 5, more preferably an integer of 1 to 3, and further preferably 1. When n^{a18} is an integer of 2 or more, a plurality of R^{a16}'s or a plurality of R^{a17}'s may be the same as or different from each other.

The maleimide resin (A2) is preferably a polymaleimide resin represented by the following general formula (A2-7). 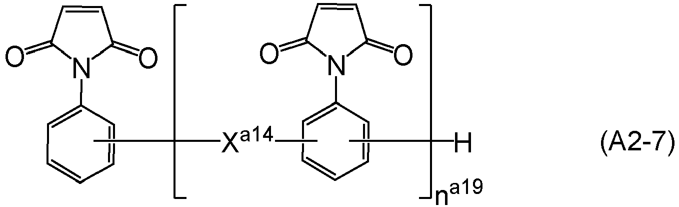 (In the formula, X^{a14}'s are each independently a divalent hydrocarbon group having 1 to 20 carbon atoms and n^{a19} is an integer of 2 to 5.)

Examples of the divalent hydrocarbon group having 1 to 20 carbon atoms represented by X^{a14} in the general formula (A2-7) include divalent aliphatic hydrocarbon groups such as an alkylene group having 1 to 5 carbon atoms and an alkylidene group having 2 to 5 carbon atoms; and a divalent hydrocarbon group including an aromatic hydrocarbon group represented by the following general formula (A2-8).

Examples of the alkylene group having 1 to 5 carbon atoms include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and further preferably a methylene group.

The alkylidene group having 2 to 5 carbon atoms is preferably an alkylidene group having 2 to 4 carbon atoms, more preferably an alkylidene group having 2 or 3 carbon atoms, and further preferably an isopropylidene group.

*-X^{a15}-Ar^{a1}-X^{a16}-* (A2-8)

(In the formula, Ar^{a1} is a divalent aromatic hydrocarbon group, X^{a15} and X^{a16} are each independently a divalent aliphatic hydrocarbon group having 1 to 5 carbon atoms, and * represents a binding moiety.)

Examples of the divalent aliphatic hydrocarbon group having 1 to 5 carbon atoms represented by X^{a15} and X^{a16} in the general formula (A2-8) are the same as the examples of the alkylene group having 1 to 5 carbon atoms, the alkylidene group having 2 to 5 carbon atoms, and the like as X^{a14} in the general formula (A2-7). Among them, a methylene group is preferred.

Examples of the divalent aromatic hydrocarbon group represented by Ar^{a1} in the general formula (A2-8) include a phenylene group, a naphthylene group, a biphenylene group, and an anthranylene group. Among them, a biphenylene group is preferred. Examples of the biphenylene group include a 4,2'-biphenylene group, a 4,3'-biphenylene group, a 4,4'-biphenylene group, and a 3,3'-biphenylene group. Among them, a 4,4'-biphenylene group is preferred.

Among the options, X^{a14} in the general formula (A2-7) is preferably a divalent hydrocarbon group including the aromatic hydrocarbon group represented by the general formula (A2-8), and more preferably a divalent hydrocarbon group represented by the general formula (A2-8) in which X^{a15} and X^{a16} are a methylene group and Ar^{a1} is a 4,4'-biphenylene group.

n^{a19} in the general formula (A2-7) is an integer of 2 to 5, preferably an integer of 2 to 4, and more preferably 2 or 3.

Examples of the maleimide resin (A2) include an aromatic bismaleimide resin, an aromatic polymaleimide resin, and an aliphatic maleimide resin.

Specific examples of the maleimide resin (A2) include N,N'-ethylenebismaleimide, N,N'-hexamethylenebismaleimide, N,N'-(1,3-phenylene)bismaleimide, N,N'-[1,3-(2-methylphenylene)]bismaleimide, N,N'-[1,3-(4-methylphenylene)]bismaleimide, N,N'-(1,4-phenylene)bismaleimide, bis(4-maleimidophenyl)methane, bis(3-methyl-4-maleimidophenyl)methane, 3,3'-dimethyl-5,5'-diethyl-4,4'-diphenylmethanebismaleimide, bis(4-maleimidophenyl)ether, bis(4-maleimidophenyl)sulfone, bis(4-maleimidophenyl)sulfide, bis(4-maleimidophenyl)ketone, bis(4-maleimidocyclohexyl)methane, 1,4-bis(4-maleimidophenyl)cyclohexane, 1,4-bis(maleimidomethyl)cyclohexane, 1,4-bis(maleimidomethyl)benzene, 1,3-bis(4-maleimidophenoxy)benzene, 1,3-bis(3-maleimidophenoxy)benzene, bis[4-(3-maleimidophenoxy)phenyl]methane, bis[4-(4-maleimidophenoxy)phenyl]methane, 1,1-bis[4-(3-maleimidophenoxy)phenyl]ethane, 1,1-bis[4-(4-maleimidophenoxy)phenyl]ethane, 1,2-bis[4-(3-maleimidophenoxy)phenyl]ethane, 1,2-bis[4-(4-maleimidophenoxy)phenyl]ethane, 2,2-bis[4-(3-maleimidophenoxy)phenyl]propane, 2,2-bis[4-(4-maleimidophenoxy)phenyl]propane, 2,2-bis[4-(3-maleimidophenoxy)phenyl]butane, 2,2-bis[4-(4-maleimidophenoxy)phenyl]butane, 2,2-bis[4-(3-maleimidophenoxy)phenyl]-1,1,1,3,3,3-hexafluoropropane, 2,2-bis[4-(4-maleimidophenoxy)phenyl]-1,1,1,3,3,3-hexafluoropropane, 4,4-bis(3-maleimidophenoxy)biphenyl, 4,4-bis(4-maleimidophenoxy)biphenyl, bis[4-(3-maleimidophenoxy)phenyl]ketone, bis[4-(4-maleimidophenoxy)phenyl]ketone, bis(4-maleimidophenyl)disulfide, bis[4-(3-maleimidophenoxy)phenyl]sulfide, bis[4-(4-maleimidophenoxy)phenyl]sulfide, bis[4-(3-maleimidophenoxy)phenyl]sulfoxide, bis[4-(4-maleimidophenoxy)phenyl]sulfoxide, bis[4-(3-maleimidophenoxy)phenyl]sulfone, bis[4-(4-maleimidophenoxy)phenyl]sulfone, bis[4-(3-maleimidophenoxy)phenyl]ether, bis[4-(4-maleimidophenoxy)phenyl]ether, 1,4-bis[4-(4-maleimidophenoxy)-α,α-dimethylbenzyl]benzene, 1,3-bis[4-(4-maleimidophenoxy)-α,α-dimethylbenzyl]benzene, 1,4-bis[4-(3-maleimidophenoxy)-α,α-dimethylbenzyl]benzene, 1,3-bis[4-(3-maleimidophenoxy)-α,α-dimethylbenzyl]benzene, 1,4-bis[4-(4-maleimidophenoxy)-3,5-dimethyl-α,α-dimethylbenzyl]benzene, 1,3-bis[4-(4-maleimidophenoxy)-3,5-dimethyl-α,α-dimethylbenzyl]benzene, 1,4-bis[4-(3-maleimidophenoxy)-3,5-dimethyl-α,α-dimethylbenzyl]benzene, 1,3-bis[4-(3-maleimidophenoxy)-3,5-dimethyl-α,α-dimethylbenzyl]benzene, polyphenylmethanemaleimide, and biphenylaralkyl-type maleimide.

### (Maleimide Resin Derivative (AY))

The maleimide resin derivative (AY) is preferably an aminomaleimide resin having a structural unit derived from the maleimide resin (AX) and a structural unit derived from a diamine compound (hereinafter sometimes referred to as "aminomaleimide resin (A3)" or "component (A3)").

### [Aminomaleimide Resin (A3)]

The aminomaleimide resin (A3) has a structural unit derived from the maleimide resin (AX) and a structural unit derived from a diamine compound (hereinafter sometimes referred to as "diamine compound (a)" or "component (a)").

### «Structural Unit Derived from Maleimide Resin (AX)»

Examples of the structural unit derived from the maleimide resin (AX) include a structural unit obtained by a Michael addition reaction between at least one N-substituted maleimide group of the N-substituted maleimide groups in the maleimide resin (AX) and an amino group in the diamine compound.

The aminomaleimide resin (A3) may contain one type of the structural unit derived from the maleimide resin (AX) or two or more types thereof.

The content of the structural unit derived from the maleimide resin (AX) in the aminomaleimide resin (A3) is not particularly limited, and is preferably 5 to 95 mass%, more preferably 30 to 93 mass%, and further preferably 60 to 90 mass%. When the content of the structural unit derived from the maleimide resin (AX) in the aminomaleimide resin (A3) falls within the aforementioned range, dielectric properties and film handling properties tend to be improved.

### «Structural Unit Derived from Diamine Compound (a)»

Examples of the structural unit derived from the diamine compound (a) include a structural unit obtained by a Michael addition reaction between one or two amino groups of the two amino groups in the diamine compound (a) and the N-substituted maleimide group in the maleimide resin (AX).

The aminomaleimide resin (A3) may contain one type of the structural unit derived from the diamine compound (a) or two or more types thereof.

The content of the structural unit derived from the diamine compound (a) in the aminomaleimide resin (A3) is not particularly limited, and is preferably 5 to 95 mass%, more preferably 7 to 70 mass%, and further preferably 10 to 40 mass%. When the content of the structural unit derived from the diamine compound (a) in the aminomaleimide resin (A3) falls within the aforementioned range, dielectric properties, heat resistance, flame retardant, and glass transition temperature tend to be improved.

As the diamine compound (a), for example, the same one as an amine compound having at least two primary amino groups in one molecule described in JP 2020-200406 A can be used.

Specific examples of the diamine compound (a) include 4,4'-diaminodiphenylmethane, 3,3'-dimethyl-4,4'-diaminodiphenylmethane, 3,3'-diethyl-4,4'-diaminodiphenylmethane, 4,4'-diaminodiphenyl ether, 4,4'-diaminodiphenyl sulfone, 3,3'-diaminodiphenyl sulfone, 4,4'-diaminodiphenyl ketone, 4,4'-diaminobiphenyl, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3'-dimethyl-5,5'-diethyl-4,4'-diaminodiphenylmethane, 2,2-bis(4-aminophenyl)propane, 2,2-bis[4-(4-aminophenoxy)phenyl]propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, 1,3-bis[1-[4-(4-aminophenoxy)phenyl]-1-methylethyl]benzene, 1,4-bis[1-[4-(4-aminophenoxy)phenyl]-1-methylethyl]benzene, 4,4'-[1,3-phenylenebis(1-methylethylidene)]bisaniline, 4,4'-[1,4-phenylenebis(1-methylethylidene)]bisaniline, 3,3'-[1,3-phenylenebis(1-methylethylidene)]bisaniline, bis[4-(4-aminophenoxy)phenyl]sulfone, bis[4-(3-aminophenoxy)phenyl]sulfone, and 9,9-bis(4-aminophenyl)fluorene.

The ratio (Ta2/Ta1) of the total equivalent weight (Ta2) of a group derived from a - NH₂ group in the diamine compound (a) (including -NH₂) to the total equivalent weight (Ta1) of a group derived from the N-substituted maleimide group in the maleimide resin (AX), in the aminomaleimide resin (A3), is not particularly limited, and from the viewpoint of dielectric properties, heat resistance, flame retardant, and glass transition temperature, it is preferably 0.05 to 10, more preferably 0.5 to 7, and further preferably 1 to 5. The group derived from the -NH₂ group in the diamine compound (a) also includes -NH₂. The group derived from the N-substituted maleimide group in the maleimide resin (AX) also includes the N-substituted maleimide group.

The number average molecular weight of the aminomaleimide resin (A3) is not particularly limited, and from the viewpoint of handleability and moldability, it is preferably 400 to 10,000, more preferably 500 to 5,000, and further preferably 600 to 2,000.

The aminomaleimide resin (A3) can be produced, for example, by a method described in "Method for producing modified maleimide resin (A)" in JP 2020-200406 A.

Of the thermosetting resin (A) described above, from the viewpoint of dielectric properties, conductor adhesive properties, and heat resistance, the thermosetting resin (A) is preferably a maleimide resin containing a condensed ring of an aromatic ring and an aliphatic ring in a molecular structure and having two or more N-substituted maleimide groups.

It is preferable that the thermosetting resin (A) have a viscosity at 25°C measured by the aforementioned method be more than 100,000 mPa·s, and it is more preferable that the thermosetting resin (A) be in a solid state at 25°C.

### (Content of Thermosetting Resin (A))

In the resin composition of the embodiment, the content of the thermosetting resin (A) is not particularly limited, and is preferably 5 to 60 mass%, more preferably 8 to 40 mass%, further preferably 10 to 30 mass%, and particularly preferably 15 to 25 mass%, relative to the total amount (100 mass%) of a resin component in the resin composition of the embodiment.

When the content of the thermosetting resin (A) is equal to or more than the lower limit value, heat resistance, moldability, processability, and conductor adhesive properties tend to be improved. When the content of the thermosetting resin (A) is equal to or less than the upper limit value, dielectric properties tend to be improved.

The "resin component" used herein means a resin and a compound forming a resin by a curing reaction.

In the resin composition of the embodiment, for example, the thermosetting resin (A) and the reactive liquid compound (B) correspond to the resin component.

The upper limit value of the content of the thermosetting resin (A) may be 80 mass% or less, 70 mass% or less, or 60 mass% or less, relative to the total amount (100 mass%) of the thermosetting resin (A) and the reactive liquid compound (B). The lower limit value of the content of the thermosetting resin (A) may be 5 mass% or more, 10 mass% or more, or 15 mass% or more, relative to the total amount (100 mass%) of the thermosetting resin (A) and the reactive liquid compound (B).

When the resin composition of the embodiment contains as an optional component the resin or the compound forming a resin by a curing reaction in addition to the components, the resin component includes the optional component. Examples of the optional component corresponding to the resin component include (D) an elastomer having a molecular weight of more than 1,000 and (E) a curing accelerator, as described below.

Here, the resin component does not include the inorganic filler (C).

In the resin composition of the embodiment, the content of the resin component is not particularly limited, and from the viewpoint of low thermal expansibility, heat resistance, flame retardant, and conductor adhesive properties, it is preferably 5 to 80 mass%, more preferably 10 to 60 mass%, and further preferably 20 to 40 mass%, relative to the total amount (100 mass%) of solid content of the resin composition of the embodiment.

The content of the maleimide-based resin in the thermosetting resin (A) is not particularly limited, and is preferably 80 to 100 mass%, more preferably 90 to 100 mass%, and further preferably 95 to 100 mass%, relative to the total amount (100 mass%) of the thermosetting resin (A).

When the content of the maleimide-based resin is equal to or more than the lower limit value, heat resistance, moldability, processability, and conductor adhesive properties tend to be improved. When the content of the maleimide-based resin is equal to or less than the upper limit value, dielectric properties tend to be improved.

### <Reactive Liquid Compound (B)>

The reactive liquid compound (B) is not particularly limited as long as it is a compound that is in a liquid state at 25°C, has a reactive group, and has a molecular weight of 1,000 or less.

One type of the reactive liquid compound (B) may be used alone, or two or more types thereof may be used in combination.

The reactive liquid compound (B) preferably has two or more reactive groups, more preferably two to five reactive groups, further preferably two to four reactive groups, and particularly preferably two or three reactive groups in one molecule.

When the number of reactive groups falls within the aforementioned range, volatilization during heating and curing is effectively suppressed, and excellent flexibility tends to be easily achieved.

The molecular weight of the reactive liquid compound (B) is 1,000 or less, preferably 100 to 800, more preferably 150 to 600, and further preferably 200 to 400.

When the molecular weight of the reactive liquid compound (B) is equal to or more than the lower limit value, volatilization of the reactive liquid compound (B) tends to be easily suppressed before heating and curing of the resin composition. When the molecular weight of the reactive liquid compound (B) is equal to or less than the upper limit value, more excellent flexibility tends to be easily achieved.

The viscosity at 25°C of the reactive liquid compound (B) is preferably 1 to 5,000 mPa·s, more preferably 2 to 1,000 mPa·s, and further preferably 4 to 500 mPa·s.

When the viscosity at 25°C of the reactive liquid compound (B) is equal to or more than the lower limit value, volatilization of the reactive liquid compound (B) tends to be easily suppressed. When the viscosity at 25°C of the reactive liquid compound (B) is equal to or less than the upper limit value, more excellent flexibility tends to be easily achieved.

The viscosity at 25°C of the reactive liquid compound (B) can be measured by the measurement method described above.

It is preferable that the reactive liquid compound (B) have as the reactive group one or more selected from a vinyl group, an allyl group, a maleimide group, a (meth)acryloyl group, an epoxy group, a hydroxy group, a carboxy group, and an amino group. Among them, the reactive group is preferably a (meth)acryloyl group or an epoxy group, and further preferably a (meth)acryloyl group from the viewpoint of easily achieving more excellent dielectric properties.

Specific examples of the reactive liquid compound (B) having as the reactive group a (meth)acryloyl group include (meth)acrylates such as a mono(meth)acrylate, a di(meth)acrylate, and a (meth)acrylate having three or more functional groups.

Examples of the mono(meth)acrylate include methyl (meth)acrylate, ethyl (meth)acrylate, propyl (meth)acrylate, butyl (meth)acrylate, pentyl (meth)acrylate, hexyl (meth)acrylate, heptyl (meth)acrylate, 2-ethylhexyl (meth)acrylate, octyl (meth)acrylate, isooctyl (meth)acrylate, nonyl (meth)acrylate, decyl (meth)acrylate, dodecyl (meth)acrylate, lauryl (meth)acrylate, tridecyl (meth)acrylate, stearyl (meth)acrylate, cyclohexyl (meth)acrylate, cyclopentyl (meth)acrylate, benzyl (meth)acrylate, dicyclopentenyl (meth)acrylate, dicyclopentenyloxyethyl (meth)acrylate, methoxyethyl (meth)acrylate, ethoxyethyl (meth)acrylate, butoxyethyl (meth)acrylate, phenoxyethyl (meth)acrylate, 2-hydroxyethyl (meth)acrylate, 2-hydroxypropyl (meth)acrylate, and 4-hydroxybutyl (meth)acrylate.

Examples of the di(meth)acrylate include 1,4-butanediol di(meth)acrylate, 1,6-hexanediol di(meth)acrylate, 1,9-nonanediol di(meth)acrylate, 1,10-decanediol di(meth)acrylate, tricyclodecane di(meth)acrylate, 1,12-dodecanediol di(meth)acrylate, ethylene glycol di(meth)acrylate, diethylene glycol di(meth)acrylate, triethylene glycol di(meth)acrylate, polyethylene glycol di(meth)acrylate, propylene glycol di(meth)acrylate, dipropylene glycol di(meth)acrylate, tripropylene glycol di(meth)acrylate, polypropylene glycol di(meth)acrylate, neopentyl glycol di(meth)acrylate, ethoxylated bisphenol A di(meth)acrylate, ethoxylated bisphenol F di(meth)acrylate, and dioxane glycol di(meth)acrylate.

Examples of dioxane glycol di(meth)acrylate include acrylic acid 2-[5-ethyl-5-[(acryloyloxy)methyl]-1,3-dioxan-2-yl]-2,2-dimethylethyl.

Examples of the (meth)acrylate having three or more functional groups include trimethylolpropane tri(meth)acrylate, pentaerythritol tri(meth)acrylate, and dipentaerythritol hexa(meth)acrylate.

Among the options, the (meth)acrylate is preferably a di(meth)acrylate.

The di(meth)acrylate is preferably a diacrylate represented by the following general formula (B-1) or a dimethacrylate represented by the following general formula (B-2), and more preferably a dimethacrylate represented by the following general formula (B-2). 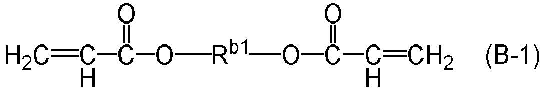 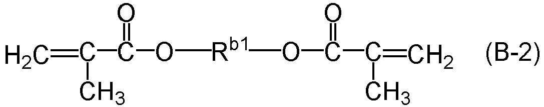 (In the formulae, R^{b1} is an alkylene group having 1 to 20 carbon atoms.)

The number of carbon atoms in the alkylene group having 1 to 20 carbon atoms represented by R^{b1} in the general formulae (B-1) and (B-2) is preferably 4 to 18, more preferably 6 to 15, and further preferably 8 to 12.

Examples of the alkylene group having 1 to 20 carbon atoms include a methylene group, an ethylene group, a propylene group, a butylene group, a pentylene group, a hexylene group, a heptylene group, an octylene group, a nonylene group, a decylene group, an undecylene group, a dodecylene group, a tetradecylene group, and a pentadecylene group. The alkylene group may be linear, branched, or cyclic, and is preferably linear.

### (Content of Reactive Liquid Compound (B))

In the resin composition of the embodiment, the content of the reactive liquid compound (B) is not particularly limited, and is preferably 5 to 60 mass%, more preferably 8 to 40 mass%, further preferably 10 to 30 mass%, and particularly preferably 15 to 25 mass%, relative to the total amount (100 mass%) of the resin component in the resin composition of the embodiment.

When the content of the reactive liquid compound (B) is equal to or more than the lower limit value, more excellent flexibility tends to be easily achieved. When the content of the reactive liquid compound (B) is equal to or less than the upper limit value, generation of a volatile component tends to be easily suppressed during heating and curing.

In the resin composition of the embodiment, the content of the component (B) is preferably 1 to 20 mass%, more preferably 3 to 15 mass%, and further preferably 5 to 10 mass%, relative to the total amount (100 mass%) of the components (A), (B), and (C).

When the content of the reactive liquid compound (B) is equal to or more than the lower limit value, more excellent flexibility tends to be easily achieved. When the content of the reactive liquid compound (B) is equal to or less than the upper limit value, generation of a volatile component tends to be easily suppressed during heating and curing.

### <Inorganic Filler (C)>

When the resin composition of the embodiment contains the inorganic filler (C), more excellent low thermal expansibility, heat resistance, and flame retardant tend to be easily achieved.

One type of the inorganic filler (C) may be used alone, or two or more types thereof may be used in combination.

Examples of the inorganic filler (C) include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, talc, aluminum borate, and silicon carbide. Among them, from the viewpoint of low thermal expansibility, heat resistance, and flame retardant, silica, alumina, mica, and talc are preferred, and silica and alumina are more preferred.

Examples of the silica include precipitated silica having a high moisture content that is produced by a wet method and dry silica containing few bound water and the like that is produced by a dry method. Specific examples of the dry silica include crushed silica, fumed silica, and molten silica, which depend on a production method.

The average particle diameter of the inorganic filler (C) is not particularly limited, and from the viewpoint of dispersibility of the inorganic filler (C) and formation of fine wiring, it is preferably 0.01 to 20 µm, more preferably 0.1 to 10 µm, further preferably 0.2 to 1 µm, and particularly preferably 0.3 to 0.8 µm.

The average particle diameter of the inorganic filler (C) used herein represents a particle diameter corresponding to a volume of 50% in a cumulative frequency distribution curve of particle diameter when the whole volume of particles is 100%. The average particle diameter of the inorganic filler (C) can be measured, for example, with a particle size distribution measuring device using a laser diffraction and scattering method.

The shape of the inorganic filler (C) is, for example, a spherical shape, a crushed shape, or the like, and is preferably a spherical shape.

In the resin composition of the embodiment, a coupling agent may be used to improve the dispersibility of the inorganic filler (C) and adherence to an organic component. Examples of the coupling agent include a silane coupling agent and a titanate coupling agent. Among them, a silane coupling agent is preferred. Examples of the silane coupling agent include an amino silane coupling agent, a vinyl silane coupling agent, and an epoxy silane coupling agent.

When the coupling agent is used in the resin composition of the embodiment, a method for surface-treating the inorganic filler (C) may be an integral blending method in which the inorganic filler (C) is blended in the resin composition, and the coupling agent is then added, or a method in which the inorganic filler (C) is surface-treated with the coupling agent in advance by a dry or wet method. Among them, from the viewpoint of more effectively developing advantages of the inorganic filler (C), the method in which the inorganic filler (C) is surface-treated with the coupling agent in advance by a dry or wet method is preferred.

The inorganic filler (C) in a slurry state in which the inorganic filler is dispersed in the organic solvent in advance may be mixed with other components to improve the dispersibility in the resin composition.

### (Content of Inorganic Filler (C))

In the resin composition of the embodiment, the content of the inorganic filler (C) is not particularly limited, and is preferably 20 to 95 mass%, more preferably 40 to 90 mass%, and further preferably 60 to 80 mass%, relative to the total amount (100 mass%) of solid content of the resin composition.

When the content of the inorganic filler (C) is equal to or more than the lower limit value, low thermal expansibility, heat resistance, and flame retardant tend to be easily improved. When the content of the inorganic filler (C) is equal to or less than the upper limit value, moldability and conductor adhesive properties tend to be easily improved.

### <Elastomer (D) Having Molecular Weight of More Than 1,000>

The resin composition of the embodiment preferably further contains (D) an elastomer having a molecular weight of more than 1,000 (hereinafter sometimes referred to as "elastomer (D)" or "component (D)").

When the resin composition of the embodiment contains the elastomer (D), more excellent dielectric properties tend to be easily achieved.

The "elastomer" used herein means a polymer having a glass transition temperature of 25°C or lower, which is determined by differential scanning calorimetry in accordance with JIS K 6240:2011.

One type of the elastomer (D) may be used alone, or two or more types thereof may be used in combination.

The molecular weight of the elastomer (D) is more than 1,000, preferably 1,050 to 500,000, more preferably 1,100 to 350,000, and further preferably 1,150 to 200,000.

When the molecular weight of the elastomer (D) is equal to or more than the lower limit value, the heat resistance and the like of the obtained resin composition tend to be easily and favorably kept. When the molecular weight of the elastomer (D) is equal to or less than the upper limit value, the dielectric properties and conductor adhesive properties of the obtained resin composition tend to be easily improved.

Preferable examples of the elastomer (D) include a conjugated diene polymer (D1), a modified conjugated diene polymer (D2), and a styrene-based elastomer (D3).

Hereinafter, preferable aspects of these components will be described.

### (Conjugated Diene Polymer (D1))

The "conjugated diene polymer" used herein means a polymer of conjugated diene compound.

When the resin composition of the embodiment contains the conjugated diene polymer (D1), more excellent dielectric properties tend to be easily achieved.

One type of the conjugated diene polymer (D1) may be used alone, or two or more types thereof may be used in combination.

Examples of the conjugated diene compound include 1,3-butadiene, isoprene, 1,3-pentadiene, 2,3-dimethyl-1,3-butadiene, 2-phenyl-1,3-butadiene, and 1,3-hexadiene.

The conjugated diene polymer (D1) may be a polymer of one type of conjugated diene compound or a copolymer of two or more types of conjugated diene compounds.

The conjugated diene polymer (D1) may be a copolymer of one or more types of conjugated diene compounds and a monomer other than the conjugated diene compounds.

When the conjugated diene polymer (D1) is a copolymer, a polymerization form is not particularly limited, and may be random polymerization, block polymerization, or graft polymerization.

From the viewpoint of compatibility with the other resin and dielectric properties, the conjugated diene polymer (D1) is preferably a conjugated diene polymer having a plurality of vinyl groups on a side chain.

The number of vinyl groups in one molecule of the conjugated diene polymer (D1) is not particularly limited, and from the viewpoint of compatibility with the other resin and dielectric properties, it is preferably 3 or more, more preferably 5 or more and further preferably 10 or more.

The upper limit of the number of vinyl groups in one molecule of the conjugated diene polymer (D1) is not particularly limited, and may be 100 or less, 80 or less, or 60 or less.

Examples of the conjugated diene polymer (D1) include a polybutadiene having a 1,2-vinyl group, a butadiene-styrene copolymer having a 1,2-vinyl group, and a polyisoprene having a 1,2-vinyl group. Among them, from the viewpoint of dielectric properties and heat resistance, a polybutadiene having a 1,2-vinyl group and a butadiene-styrene copolymer having a 1,2-vinyl group are preferred, and a polybutadiene having a 1,2-vinyl group is more preferred. The polybutadiene having a 1,2-vinyl group is preferably a polybutadiene homopolymer having a 1,2-vinyl group.

A 1,2-vinyl group derived from butadiene in the conjugated diene polymer (D1) is a vinyl group contained in a butadiene-derived structural unit represented by the following formula (D1-1).

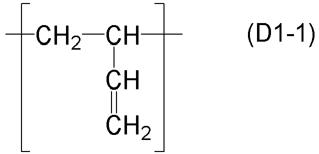

When the conjugated diene polymer (D1) is a polybutadiene having a 1,2-vinyl group, the content of the structural unit having a 1,2-vinyl group relative to the whole of structural unit derived from butadiene constituting a polybutadiene (hereinafter sometimes referred to as "vinyl group content") is not particularly limited. From the viewpoint of compatibility with the other resin, dielectric properties, and heat resistance, it is preferably 50 mol% or more, more preferably 70 mol% or more, and further preferably 85 mol% or more. The upper limit of the vinyl group content is not particularly limited, and may be 100 mol% or less, 95 mol% or less, or 90 mol% or less. The structural unit having a 1,2-vinyl group is preferably a butadiene-derived structural unit represented by the formula (D1-1).

From the same viewpoint, the polybutadiene having a 1,2-vinyl group is preferably a 1,2-polybutadiene homopolymer.

The number average molecular weight of the conjugated diene polymer (D1) is not particularly limited, and from the viewpoint of compatibility with the other resin, dielectric properties, and heat resistance, it is preferably 1,050 to 3,000, more preferably 1,100 to 2,000, and further preferably 1,150 to 1,500.

### (Modified Conjugated Diene Polymer (D2))

The modified conjugated diene polymer (D2) is a polymer in which a conjugated diene polymer is modified.

When the resin composition of the embodiment contains the modified conjugated diene polymer (D2), more excellent dielectric properties tend to be easily achieved in addition to favorable heat resistance and low thermal expansibility.

One type of the modified conjugated diene polymer (D2) may be used alone, or two or more types thereof may be used in combination.

For example, when the thermosetting resin (A) contains a maleimide-based resin, from the viewpoint of compatibility with the other resin, dielectric properties, and conductor adhesive properties, the modified conjugated diene polymer (D2) is preferably a modified conjugated diene polymer in which a conjugated diene polymer having a vinyl group on a side chain (d1) (hereinafter sometimes referred to as "conjugated diene polymer (d1)") is modified with a maleimide resin having two or more N-substituted maleimide groups (d2) (hereinafter sometimes referred to as "maleimide resin (d2)").

As the conjugated diene polymer (d1), for example, the conjugated diene polymer having a vinyl group on a side chain described as the conjugated diene polymer (D1) can be used, and preferable aspects of the conjugated diene polymer (d1) are the same as those of the conjugated diene polymer (D1).

One type of the conjugated diene polymer (d1) may be used alone, or two or more types thereof may be used in combination.

As the maleimide resin (d2), for example, the maleimide resin having two or more N-substituted maleimide groups described as the maleimide resin (AX) can be used, and preferable aspects of the maleimide resin (d2) are the same as those of the maleimide resin (AX).

One type of the maleimide resin (d2) may be used alone, or two or more types thereof may be used in combination.

The modified conjugated diene polymer (D2) preferably has on a side chain a substituent (hereinafter sometimes referred to as "substituent (x)") obtained by a reaction of the vinyl group in the conjugated diene polymer (d1) and the N-substituted maleimide group in the maleimide resin (d2).

From the viewpoint of compatibility with the other resin, dielectric properties, low thermal expansibility, and heat resistance, the substituent (x) is preferably a group having a structure represented by the following general formula (D2-1) or (D2-2) as a structure derived from the maleimide resin (d2). 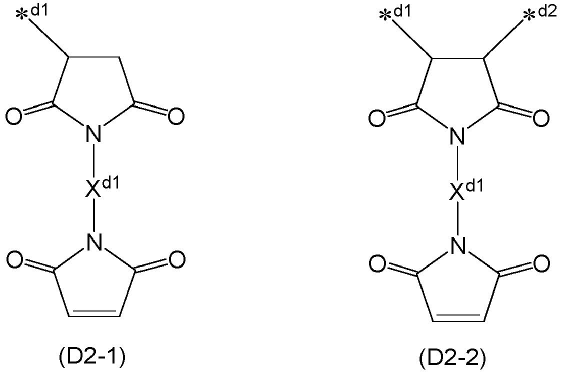 (In the formulae, X^{d1} is a divalent group obtained by removing two N-substituted maleimide groups from the maleimide resin (d2), *^{d1} is a moiety in which the conjugated diene polymer (d1) binds to a carbon atom derived from the vinyl group on the side chain, and *^{d2} is a moiety that binds to another atom.)

The modified conjugated diene polymer (D2) preferably has on a side chain the substituent (x) and a vinyl group (y).

The proportion of the substituent (x) in the modified conjugated diene polymer (D2) may be an index that determines how many vinyl groups in the conjugated diene polymer (d1) are modified with the maleimide resin (d2) (hereinafter sometimes referred to as "vinyl group modification rate").

The vinyl group modification rate is not particularly limited, and from the viewpoint of compatibility with the other resin, dielectric properties, low thermal expansibility, and heat resistance, it is preferably 20 to 70%, more preferably 30 to 60%, and further preferably 35 to 50%. The vinyl group modification rate used herein is a value determined by a method described in Examples.

The vinyl group (y) is preferably a 1,2-vinyl group in the butadiene-derived structural unit.

The number average molecular weight of the modified conjugated diene polymer (D2) is not particularly limited, and from the viewpoint of compatibility with the other resin, dielectric properties, low thermal expansibility, and heat resistance, it is preferably 1,100 to 6,000, more preferably 1,300 to 4,000, and further preferably 1,500 to 2,000.

The modified conjugated diene polymer (D2) can be produced by reacting the conjugated diene polymer (d1) with the maleimide resin (d2).

Amethod for reacting the conjugated diene polymer (d1) with the maleimide resin (d2) is not particularly limited. For example, the conjugated diene polymer (d1), the maleimide resin (d2), a reaction catalyst, and an organic solvent are placed in a reaction vessel, and a reaction is caused by heating, keeping the temperature, stirring, or the like, if necessary. Thus, the modified conjugated diene polymer (D2) can be obtained.

From the viewpoint of workability and suppression of gelation of the product in the reaction, the reaction temperature of the reaction is preferably 70 to 120°C, more preferably 80 to 110°C, and further preferably 85 to 105°C.

From the viewpoint of productivity and sufficient promotion of the reaction, the reaction time of the reaction is preferably 0.5 to 15 hours, more preferably 1 to 10 hours, and further preferably 3 to 7 hours.

These reaction conditions can be appropriately adjusted depending on the types of used raw materials, and the like, and are not particularly limited.

Examples of the organic solvent used in the reaction include alcohol-based solvents such as methanol, ethanol, butanol, butyl cellosolve, ethylene glycol monomethyl ether, and propylene glycol monomethyl ether; ketone-based solvents such as acetone, methyl ethyl ketone, methyl isobutyl ketone, and cyclohexanone; aromatic hydrocarbon-based solvents such as toluene, xylene, and mesitylene; ester-based solvents such as methoxyethyl acetate, ethoxyethyl acetate, butoxyethyl acetate, and ethyl acetate; and nitrogen atom-containing solvents such as N,N-dimethylformamide, N,N-dimethylacetamide, and N-methyl-2-pyrrolidone.

One type of the organic solvent may be used alone, or two or more types thereof may be used in combination. Among these, from the viewpoint of resin solubility, toluene is preferred.

When the reaction is performed in the organic solvent, the total content of the conjugated diene polymer (d1) and the maleimide resin (d2) in the reaction solution is not particularly limited, and is preferably 10 to 70 mass%, more preferably 15 to 60 mass%, and further preferably 20 to 50 mass%. When the total content of the conjugated diene polymer (d1) and the maleimide resin (d2) is equal to or more than the lower limit value, a favorable reaction rate is achieved, and productivity tends to be improved. When the total content of the conjugated diene polymer (d1) and the maleimide resin (d2) is equal to or less than the upper limit value, favorable solubility is achieved, stirring efficiency is improved, and gelation of the product in the reaction tends to be suppressed.

From the viewpoint of suppressing the gelation of the product in the reaction and achieving sufficient reactivity, the reaction catalyst is preferably an organic peroxide. As the organic peroxide, one exemplified as a curing accelerator (E) described below can be used.

One type of the reaction catalyst may be used alone, or two or more types thereof may be used in combination.

The amount of the reaction catalyst used is not particularly limited, and from the viewpoint of reaction rate and reaction uniformity, it is preferably 0.001 to 1 parts by mass, more preferably 0.003 to 0.1 parts by mass, and further preferably 0.005 to 0.02 parts by mass, relative to 100 parts by mass of the total amount of the conjugated diene polymer (d1) and the maleimide resin (d2).

The ratio (Mₘ/Mᵥ) of the amount by mole (Mₘ) of the N-substituted maleimide group in the maleimide resin (d2) to the amount by mole (Mᵥ) of the side-chain vinyl group in the conjugated diene polymer (d1) in the reaction is not particularly limited. From the viewpoint of compatibility with the other resin of the obtained modified conjugated diene polymer (D2) and suppression of gelation of the product in the reaction, it is preferably 0.001 to 0.5, more preferably 0.005 to 0.1, and further preferably 0.008 to 0.05.

### <Styrene-based Elastomer (D3)>

The styrene-based elastomer (D3) is not particularly limited as long as it is an elastomer having a structural unit derived from a styrene-based compound.

When the resin composition of the embodiment contains the styrene-based elastomer (D3), more excellent dielectric properties tend to be easily achieved.

One type of the styrene-based elastomer (D3) may be used alone, or two or more types thereof may be used in combination.

The styrene-based elastomer (D3) is preferably an elastomer having a structural unit derived from a styrene-based compound that is represented by the following general formula (D3-1). 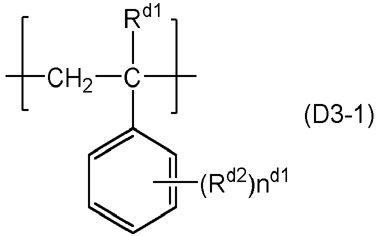 (In the formula, R^{d1} is a hydrogen atom or an alkyl group having 1 to 5 carbon atoms, R^{d2} is an alkyl group having 1 to 5 carbon atoms, and n^{d1} is an integer of 0 to 5.)

Examples of the alkyl group having 1 to 5 carbon atoms represented by R^{d1} and R^{d2} in the general formula (D3-1) include a methyl group, an ethyl group, an n-propyl group, an isopropyl group, an n-butyl group, an isobutyl group, a t-butyl group, and an n-pentyl group. The alkyl group having 1 to 5 carbon atoms may be linear or branched. Among them, an alkyl group having 1 to 3 carbon atoms is preferred, an alkyl group having 1 or 2 carbon atoms is more preferred, and a methyl group is further preferred.

n^{d1} in the general formula (D3-1) is an integer of 0 to 5, preferably an integer of 0 to 2, more preferably 0 or 1, and further preferably 0.

The styrene-based elastomer (D3) may contain a structural unit other than the structural unit derived from a styrene-based compound.

Examples of the structural unit other than the structural unit derived from the styrene-based compound that may be contained in the styrene-based elastomer (D3) include a butadiene-derived structural unit, an isoprene-derived structural unit, a maleic acid-derived structural unit, and a maleic anhydride-derived structural unit.

The butadiene-derived structural unit and the isoprene-derived structural unit may be hydrogenated. When the structural units are hydrogenated, the butadiene-derived structural unit is a structural unit in which an ethylene unit and a butylene unit are mixed, and the isoprene-derived structural unit is a structural unit in which an ethylene unit and a propylene unit are mixed.

Examples of the styrene-based elastomer (D3) include a hydrogenated product of a styrene-butadiene-styrene block copolymer, a hydrogenated product of a styrene-isoprene-styrene block copolymer, and a styrene-maleic anhydride copolymer.

Examples of the hydrogenated product of a styrene-butadiene-styrene block copolymer include SEBS in which a carbon-carbon double bond in a butadiene block is completely hydrogenated and SBBS in which a carbon-carbon double bond at a 1,2-binding moiety in a butadiene block is partially hydrogenated. The complete hydrogenation in SEBS may be usually 90% or more, 95% or more, 99% or more, or 100%, of the whole carbon-carbon double bond. The partial hydrogenation in SBBS may be, for example, 60 to 85% of the whole carbon-carbon double bond. The hydrogenated product of a styrene-isoprene-styrene block copolymer is obtained as SEPS by hydrogenating a polyisoprene moiety.

Among them, from the viewpoint of dielectric properties, conductor adhesive properties, heat resistance, glass transition temperature, and low thermal expansibility, SEBS and SEPS are preferred, and SEBS is more preferred.

In the SEBS, the content of the styrene-derived structural unit (hereinafter sometimes referred to as "styrene content") is not particularly limited, and is preferably 5 to 60 mass%, more preferably 7 to 40 mass%, and further preferably 10 to 20 mass%.

The melt flow rate (MFR) of the SEBS is not particularly limited. The melt flow rate under a measurement condition of 230°C and a load of 2.16 kgf (21.2 N) is preferably 0.1 to 20 g/10 min, more preferably 1 to 10 g/10 min, and further preferably 3 to 7 g/10 min.

Examples of commercially available products of SEBS include Tuftec (registered trademark) H series and M series (available from Asahi Kasei Chemicals Corporation), SEPTON (registered trademark) series available from KURARAY CO., LTD., and KRATON (registered trademark) G polymer series available from Kraton Polymer Japan Ltd.

The number average molecular weight of the styrene-based elastomer (D3) is not particularly limited, and is preferably 10,000 to 500,000, more preferably 50,000 to 350,000, and further preferably 100,000 to 200,000.

Examples of the elastomer (D) other than the conjugated diene polymer (D1), the modified conjugated diene polymer (D2), and the styrene-based elastomer (D3) include a polyolefin resin, a polyphenylene ether resin, a polyester resin, a polyamide resin, and a polyacrylic resin other than the conjugated diene polymer (D1), the modified conjugated diene polymer (D2), and the styrene-based elastomer (D3).

### (Content of Elastomer (D))

When the resin composition of the embodiment contains the elastomer (D), the content of the elastomer (D) is not particularly limited, and is preferably 10 to 80 mass%, more preferably 30 to 70 mass%, and further preferably 50 to 60 mass%, relative to the total amount (100 mass%) of the resin component in the resin composition of the embodiment.

When the content of the elastomer (D) is equal to or more than the lower limit value, more excellent dielectric properties tend to be easily achieved. When the content of the elastomer (D) is equal to or less than the upper limit value, more excellent heat resistance tends to be easily achieved.

The total content of one or more selected from the group consisting of the conjugated diene polymer (D1), the modified conjugated diene polymer (D2), and the styrene-based elastomer (D3) is not particularly limited. From the viewpoint of dielectric properties and conductor adhesive properties, it is preferably 60 to 100 mass%, more preferably 80 to 100 mass%, and further preferably 90 to 100 mass%, relative to the total amount (100 mass%) of the elastomer (D).

From the viewpoint of dielectric properties and compatibility, the elastomer (D) preferably contains the styrene-based elastomer (D3) and one or more selected from the group consisting of the conjugated diene polymer (D1) and the modified conjugated diene polymer (D2).

When the elastomer (D) contains the styrene-based elastomer (D3) and one or more selected from the group consisting of the conjugated diene polymer (D1) and the modified conjugated diene polymer (D2), The ratio {[(D1)+(D2)]/(D3)} of the total content of the conjugated diene polymer (D1) and the modified conjugated diene polymer (D2) to the content of the styrene-based elastomer (D3) is not particularly limited. From the viewpoint of dielectric properties and compatibility, it is preferably 0.1 to 5, more preferably 0.2 to 1, and further preferably 0.3 to 0.7.

### (Curing Accelerator (E))

It is preferable that the resin composition of the embodiment further contains (E) a curing accelerator.

When the resin composition of the embodiment contains the curing accelerator (E), curing properties are improved, and more excellent dielectric properties, heat resistance, and conductor adhesive properties tend to be easily achieved.

One type of the curing accelerator (E) may be used alone, or two or more types thereof may be used in combination.

From the viewpoint of efficiently forming a chemical bond of the resin component during heating, it is preferable that a radical polymerization initiator be contained as the curing accelerator (E). The radical polymerization initiator acts as a polymerization initiator of radical polymerization, and is decomposed into a compound having an unpaired electron under exposure to energy such as light or heat. Examples of the radical polymerization initiator include an organic peroxide, an inorganic peroxide, and an azo compound described below. The organic peroxide is preferred.

Examples of the curing accelerator (E) include acidic catalysts such as p-toluenesulfonic acid; amine compounds such as triethylamine, pyridine, tributylamine, and dicyandiamide; imidazole compounds such as methylimidazole, phenylimidazole, and 1-cyanoethyl-2-phenylimidazole; isocyanate-masked imidazole compounds such as an addition reaction product of a hexamethylene diisocyanate resin and 2-ethyl-4-methylimidazole; a tertiary amine compound; a quaternary ammonium compound; phosphorous-containing compounds such as triphenyl phosphine; organic peroxides such as dicumyl peroxide, 2,5-dimethyl-2,5-bis(t-butylperoxy)hexine-3, 2,5-dimethyl-2,5-bis(t-butylperoxy)hexane, t-butylperoxy isopropyl monocarbonate, and 1,3-di(t-butylperoxy isopropyl)benzene; inorganic peroxides such as potassium persulfate, sodium persulfate, and ammonium persulfate; azo compounds such as 2,2'-azobisisobutylonitrile, 2,2'-azobis(2,4-dimethylvaleronitrile), and 2,2'-azobis(4-methoxy-2'-dimethylvaleronitrile); and carboxylic acid salts of manganese, cobalt, and zinc.

Among them, from the viewpoint of a curing accelerating effect and storage stability, an imidazole compound, an isocyanate-masked imidazole compound, an organic peroxide, and a carboxylic acid salt are preferred, and an isocyanate-masked imidazole compound and an organic peroxide are more preferred.

When the resin composition of the embodiment contains the curing accelerator (E), the content of the curing accelerator (E) is not particularly limited, and is preferably 0.1 to 15 parts by mass, more preferably 1 to 10 parts by mass, and further preferably 4 to 8 parts by mass, relative to the total amount (100 parts by mass) of the thermosetting resin (A) and the reactive liquid compound (B).

When the content of the curing accelerator (E) is equal to or more than the lower limit value, a sufficient curing accelerating effect tends to be easily achieved. When the content of the curing accelerator (E) is equal to or less than the upper limit value, storage stability tends to be improved.

When the resin composition of the embodiment contains as the curing accelerator (E) the radical polymerization initiator, the content of the radical polymerization initiator is not particularly limited, and is preferably 0.05 to 7 parts by mass, more preferably 0.5 to 5 parts by mass, and further preferably 2 to 4 parts by mass, relative to the total amount (100 parts by mass) of the thermosetting resin (A) and the reactive liquid compound (B).

When the content of the radical polymerization initiator is equal to or more than the lower limit value, a sufficient curing accelerating effect tends to be easily achieved. When the content of the radical polymerization initiator is equal to or less than the upper limit value, storage stability tends to be improved.

### <Other Component>

The resin composition of the embodiment may further contain one or more optional components selected from the group consisting of a resin material other than the aforementioned components, a flame retarder, an antioxidant, a thermal stabilizer, an antistat, an ultraviolet absorber, a pigment, a colorant, a lubricant, an organic solvent, and an additive other than the aforementioned components, if necessary.

One type of each of the optional components may be used alone, or two or more types thereof may be used in combination.

In the resin composition of the embodiment, the content of the optional component is not particularly limited, and may be used within a range not impairing the effects of the embodiment, if necessary.

The resin composition of the embodiment may not contain the optional component depending on a desired performance.

Since the resin composition of the embodiment has excellent flexibility, the resin composition is suitable as a resin composition forming a resin film.

From the viewpoint of more effectively expressing features of the resin composition of the embodiment having excellent flexibility, the resin composition of the embodiment is preferably used to form a resin film having a thickness of 10 µm or more, more preferably used to form a resin film having a thickness of 50 µm or more, further preferably used to form a resin film having a thickness of 80 µm or more, still further preferably used to form a resin film having a thickness of 100 µm or more, still further preferably used to form a resin film having a thickness of 130 µm or more, and particularly preferably used to form a resin film having a thickness of 150 µm or more.

From the viewpoint of handleability, the resin composition of the embodiment is preferably used to form a resin film having a thickness of 1,000 µm or less, more preferably used to form a resin film having a thickness of 700 µm or less, and further preferably used to form a resin film having a thickness of 500 µm or less.

### [Resin Film]

A resin film of the embodiment is a resin film including the resin composition of the embodiment.

The resin film of the embodiment can be produced, for example, by applying the resin composition of the embodiment containing the organic solvent, that is, a resin varnish to a support, followed by heating and drying.

Examples of the support include a plastic film, a metal foil, and a release paper.

Examples of the plastic film include films of polyolefins such as a polyethylene, a polypropylene, and a polyvinyl chloride; films of polyesters such as polyethylene terephthalate (hereinafter sometimes referred to as "PET") and polyethylene naphthalate; a polycarbonate film, and a polyimide film. Among them, from the viewpoint of cost efficiency and handleability, a polyethylene terephthalate film is preferred.

Examples of the metal foil include a copper foil and an aluminum foil. When a copper foil is used for the support, the copper foil is used as a conductor layer as it is, and a circuit can be formed. In this case, as the copper foil, a rolled copper foil, an electrolytic copper foil, or the like can be used. When a thin copper foil is used, a copper foil with a carrier may be used from the viewpoint of improving workability.

The support may be those subjected to surface treatment such as mat treatment or corona treatment. The support may be subjected to release treatment with a silicone resin-based release agent, an alkyd resin-based release agent, a fluororesin-based release agent, or the like.

The thickness of the support is not particularly limited, and from the viewpoint of handleability and cost efficiency, is preferably 10 to 150 µm, more preferably 20 to 100 µm, and further preferably 25 to 50 µm.

As a coater for applying a resin varnish, for example, a coater known by those of skill in the art, such as a comma coater, a bar coater, a kiss coater, a roll coater, a gravure coater, or a die coater can be used. The coater may be appropriately selected depending on the thickness of a filter to be formed.

A drying condition after applying the resin varnish and is not particularly limited, and may be appropriately determined depending on the content, boiling point, and the like of the organic solvent.

For example, in the case of a resin varnish containing 40 to 60 mass% of aromatic hydrocarbon-based solvent, the drying temperature is not particularly limited, and from the viewpoint of productivity and moderate conversion of the resin composition of the embodiment into a B-stage state, it is preferably 50 to 200°C, more preferably 80 to 150°C, and further preferably 100 to 130°C.

In the case of the resin varnish, the drying time is not particularly limited, and from the viewpoint of productivity and moderate conversion of the resin composition of the embodiment into a B-stage state, it is preferably 1 to 30 minutes, more preferably 2 to 15 minutes, and further preferably 3 to 10 minutes.

The content of the organic solvent in the resin film of the embodiment is preferably 2 mass% or less, more preferably 1 mass% or less, and further preferably 0.5 mass% or less, or may be 0 mass%, relative to the total amount (100 mass%) of the resin film.

When the content of the organic solvent in the resin film falls within the aforementioned range, the amount of the organic solvent volatilized during heating and curing tends to be easily and sufficiently reduced.

The mass reduction rate during heating and drying in an atmosphere at 170°C for 30 minutes (hereinafter sometimes referred to as "170°C mass reduction rate") of the resin film of the embodiment is preferably 2.0 mass% or less, more preferably 1.5 mass% or less, and further preferably 1.0 mass% or less, or may be 0 mass%.

When the 170°C mass reduction rate falls within the aforementioned range, the amount of a volatile component during heating and curing tends to be easily and sufficiently reduced.

The 170°C mass reduction rate can be measured by the method described in Examples.

The thickness of the resin film of the embodiment can be appropriately determined depending on the use application of the resin film. From the viewpoint of achieving sufficient insulation reliability and enabling embedding of a semiconductor chip and the like, the thickness of the resin film is preferably 10 µm or more, more preferably 50 µm or more, further preferably 80 µm or more, still further preferably 100 µm or more, still further preferably 130 µm or more, and particularly preferably 150 µm or more.

From the viewpoint of handleability, the thickness of the resin film of the embodiment is preferably 1,000 µm or less, more preferably 700 µm or less, and further preferably 500 µm or less.

The resin film of the embodiment may have a protective film. The protective film is disposed on a surface opposite to a surface on which the support of the resin film of the embodiment is disposed, and is used to prevent attachment of a foreign substance and the like to the resin film and scratching.

The relative dielectric constant (Dk) at 10 GHz of the resin composition and a cured product of the resin film of the embodiment may be less than 3.0, less than 2.9, or less than 2.8. A smaller relative dielectric constant (Dk) is favorable. The lower limit value of the relative dielectric constant is not particularly limited, and may be, for example, 2.4 or more or 2.5 or more in consideration of a balance between the relative dielectric constant and other physical properties.

The dielectric loss tangent (Df) at 10 GHz of the resin composition and the cured product of the resin film of the embodiment may be less than 0.0030, less than 0.0025, or less than 0.0015. A smaller dielectric loss tangent (Df) is favorable. The lower limit value of the dielectric loss tangent is not particularly limited, and may be, for example, 0.0010 or more or 0.0015 or more in consideration of a balance between dielectric loss tangent and other physical properties.

From the viewpoint of achieving sufficient insulation reliability and enabling embedding of a semiconductor chip and the like, the resin film of the embodiment is preferably a resin film that has a thickness of 150 µm or more and forms a cured product having a relative dielectric constant (Dk) at 10 GHz of less than 2.8 and a dielectric loss tangent (Df) of less than 0.0030.

The relative dielectric constant (Dk) and the dielectric loss tangent (Df) are values in conformity with a cavity resonator perturbation method, and more specifically, are values measured by the methods described in Examples.

For example, the resin film of the embodiment is suitable as a resin film for forming an insulating layer of a printed wiring board such as a multilayered printed wiring board or a resin film for sealing a semiconductor of a semiconductor package. In particular, since the resin film of the embodiment has excellent flexibility and excellent handleability as a thick resin film, the resin film is suitable as a resin film for sealing a semiconductor.

### [Printed Wiring Board]

A printed wiring board of the embodiment is a printed wiring board including the cured product of the resin film of the embodiment.

That is, the printed wiring board of the embodiment is considered to include the resin film of the embodiment. This " include" used herein means that a substance is formed through a state in which the substance at least includes a target.

The printed wiring board of the embodiment is preferably a multilayered printed wiring board including the cured product of the resin film of the embodiment.

That is, a multilayered printed wiring board of the embodiment includes at least a multilayer structure containing the cured product of the resin film of the embodiment and a conductor circuitry layer.

Hereinafter, a method for producing the multilayered printed wiring board of the embodiment using the resin film of the embodiment will be described.

In production of the multilayered printed wiring board using the resin film of the embodiment, the resin film of the embodiment is layered on one surface or both surfaces of a circuit substrate.

Specifically, the resin film of the embodiment is disposed on a circuit substrate and then laminated on the circuit substrate under pressurizing or heating with a vacuum laminator. Thus, the resin film of the embodiment can be layered on the circuit substrate.

Examples of a circuit substrate used for the multilayered printed wiring board include a glass epoxy substrate, a metal substrate, a polyester substrate, a polyimide substrate, a BT resin substrate, and a thermosetting polyphenylene ether substrate that have a pattern-processed conductor layer (circuit) on one surface or both surfaces thereof.

From the viewpoint of adhesive properties, the surface of the conductor layer of the circuit substrate may be previously roughened by blackening treatment or the like.

Next, the support of the resin film is peeled, if necessary, and then the resin film is heated and cured, to form an insulating layer.

The heating temperature during heating and curing is not particularly limited, and is preferably 100 to 300°C, more preferably 120 to 280°C, and further preferably 150 to 250°C.

The heating time during heating and curing is not particularly limited, and is preferably 2 to 300 minutes, more preferably 5 to 200 minutes, and further preferably 10 to 150 minutes.

After formation of the insulating layer by the aforementioned method, piercing may be carried out, if necessary. The piercing is a process in which a via hole, a through hole, or the like are formed in the circuit substrate and the formed insulating layer by piercing with a drill, a laser, a plasma, a combination thereof, or any other method. As a laser used in the piercing, for example, a carbon dioxide gas laser, a YAG laser, a UV laser, an excimer laser, or the like is used.

Subsequently, the surface of the insulating layer may be roughened by an oxidizing agent. When the insulating layer and the circuit substrate have a via hole, a through hole, or the like, a substance generated during formation of the via hole, the through hole, or the like, or a "smear" may be removed by the oxidizing agent. The roughening and removal of the smear can be carried out at the same time. By the roughening, irregular anchors can be formed on the surface of the insulating layer.

Examples of the oxidizing agent include permanganate such as potassium permanganate, and sodium permanganate, dichromate, ozone, hydrogen peroxide, sulfuric acid, and nitric acid. Among them, an aqueous sodium hydroxide solution of potassium permanganate and an aqueous sodium hydroxide solution of sodium permanganate, which are an oxidizing agent generally used in production of the multilayered printed wiring board by a build-up method, are preferred.

Next, the conductor layer is formed on the roughened surface of the insulating layer. For example, the conductor layer may be formed by plating.

Examples of a plating method include an electroless plating method and an electrolytic plating method. Examples of metal for plating include copper, gold, silver, nickel, platinum, molybdenum, ruthenium, aluminum, tungsten, iron, titanium, chromium, and alloy containing at least one of these metal elements. Among them, copper and nickel are preferred, and copper is more preferred.

A method in which a reverse pattern of a wiring pattern is firstly formed using a plating resist and the wiring pattern is formed by only electroless plating can be used.

After formation of the conductor layer, annealing treatment may be performed. By the annealing treatment, an adhesion strength between an interlayer insulating layer and the conductor layer tends to be further improved and stabilized.

As a method in which the conductor layer is pattern-processed to form a circuit, for example, a publicly known method such as a subtractive process, a full-additive process, a semi-additive process (SAP), and a modified semi-additive process (m-SAP) can be used.

### [Semiconductor Package]

A semiconductor package of the embodiment is a semiconductor package including the cured product of the resin film of the embodiment. That is, the semiconductor package of the embodiment is considered to be a semiconductor package including the resin film of the embodiment.

The semiconductor package of the embodiment may be, for example, one in which a semiconductor chip is mounted on the printed wiring board of the embodiment or one including a semiconductor chip sealed with the cured product of the resin film of the embodiment.

A semiconductor package in which a semiconductor chip is mounted on the printed wiring board of the embodiment can be produced, for example, by mounting a semiconductor chip, a memory, and the like on the printed wiring board of the embodiment through a publicly known method. The printed wiring board of the embodiment used for production of a semiconductor package is preferably a multilayered printed wiring board.

A semiconductor package having a semiconductor chip sealed with the cured product of the resin film of the embodiment can be produced, for example, by the following method.

The resin film of the embodiment is first disposed on a semiconductor chip. Subsequently, the resin film is heated and melted to embed the semiconductor chip in the resin composition constituting the resin film. After that, the resin composition in which the semiconductor chip is embedded is cured under heating. Thus, the semiconductor package in which the semiconductor chip is sealed with the cured product of the resin composition can be produced.

### Examples

Hereinafter, the embodiment will be described specifically with reference to Examples. However, the embodiment is not limited to the following Examples.

The number average molecular weight was measured by the following procedure.

### (Method for Measuring Number Average Molecular Weight)

The number average molecular weight was obtained from a calibration curve using standard polystyrene by gel permeation chromatography (GPC). The calibration curve was approximated by a cubic equation using standard polystyrene: TSKstandard POLYSTYRENE (Type: A-2500, A-5000, F-1, F-2, F-4, F-10, F-20, and F-40) (available from TOSOH CORPORATION, trade name). GPC measurement conditions are as follows.

### (GPC Measurement Conditions)

Device: high-performance GPC system HLC-8320GPC
Detector: ultraviolet absorbance detector UV-8320 (manufactured by TOSOH CORPORATION)
Column: guard column: TSK Guardcolumn SuperHZ-L + column: TSKgel SuperHZM-N + TSKgel SuperHZM-M + TSKgel SuperH-RC (all manufactured by TOSOH CORPORATION, trade name)
Column size: 4.6 × 20 mm (guard column), 4.6 × 150 mm (column), 6.0 × 150 mm (reference column)
   Eluent: tetrahydrofuran
   Sample concentration: 10 mg/5 mL
   Injection volume: 25 µL
   Flow rate: 1.00 mL/min
   Measurement temperature: 40°C

### [Production of Modified Conjugated Diene Polymer]

### Production Example 1

In a 2-L heating and cooling glass flask equipped with a thermometer, a reflux condenser, and a stirrer, 33.8 parts by mass of 1,2-polybutadiene homopolymer (number average molecular weight = 1,200, vinyl group content = 85% or more), 1.43 parts by mass of aromatic bismaleimide resin containing an indan ring (a compound represented by the general formula (A1-4-1), number average molecular weight = 1,300), 0.0035 parts by mass of t-butyl peroxy isopropyl carbonate, and toluene as an organic solvent were placed. Subsequently, a reaction was caused with stirring in a nitrogen atmosphere at 90 to 100°C for 5 hours, to obtain a solution of modified conjugated diene polymer (solid content concentration: 35 mass%). The number average molecular weight of the obtained modified conjugated diene polymer was 1,700.

A solution containing the 1,2-polybutadiene homopolymer and the aromatic bismaleimide resin containing an indan ring before initiation of the reaction and the solution after the reaction were subj ected to GPC measurement by the aforementioned method. A peak area derived from the aromatic bismaleimide resin containing an indan ring before and after the reaction was determined. Next, the vinyl group modification rate of the aromatic bismaleimide resin containing an indan ring was calculated by the following expression. The vinyl group modification rate corresponds to the reduction rate of the peak area derived from the aromatic bismaleimide resin containing an indan ring due to the reaction.

Vinyl group modification rate (%) = [(peak area derived from aromatic bismaleimide resin containing indan ring before initiation of reaction) - (peak area derived from aromatic bismaleimide resin containing indan ring after completion of reaction)] × 100 / (peak area derived from aromatic bismaleimide resin containing indan ring before initiation of reaction)

The vinyl group modification rate determined by the expression was 40%.

### [Production of Resin Composition]

### Examples 1 to 14 and Comparative Examples 1 to 3

Components listed in Table 1 and toluene were blended in blending amounts listed in Table 1, and stirred and mixed under heating at 25°C or to 50 to 80°C, to prepare a resin composition having a solid content concentration of about 50 mass%. In Table 1, the unit of blending amount of each of the components is part by mass, and in the case of solution, it means part by mass in terms of solid content.

### [Production of Resin Film]

The resin composition obtained in each Example was applied to a surface of a 50-µm PET film ("Purex A53" available from TOYOBO CO., LTD.,) such that the thickness of a dried resin layer was 150 µm. The resin composition was then heated and dried at 105°C for 5 minutes, resulting in a B-stage state. Thus, a resin film (1) with a single-sided PET film (the thickness of the resin film was 150 µm) was produced.

Next, the obtained resin film (1) with a single-sided PET film was cut into 200 mm × 200 mm. The cut resin films (1) were overlapped so as to face each other. Subsequently, the resin films (1) were bonded using a vacuum laminator at a temperature of 100°C for a pressurization time of 5 seconds, to obtain a resin film (2) with a double-sided PET film (the thickness of the resin film was 300 µm).

### [Production of Resin Plate with Double-Sided Copper Foil]

The obtained resin film (2) with a double-sided PET film was cut out into 90 mm in length and 50 mm in width, the PET film on both sides was peeled and removed, and the resin film was put in a Teflon (registered trademark) sheet die-cut into 0.3 mm in thickness, 90 mm in length, and 50 mm in width. A low-profile copper foil having a thickness of 18 µm (trade name "3EC-VLP-18" available from MITSUI MINING & SMELTING CO., LTD.) was disposed on both sides of the resin film housed in the die-cut Teflon (registered trademark) sheet. At that time, the low-profile copper foil was disposed such that the m-plane thereof faced to the resin film.

Subsequently, this laminates before molding by heating and pressurization was molded by heating and pressurization under a condition of a temperature of 180°C, a pressure of 2.0 MPa, and a time of 60 minutes, to mold and cure the resin film into a resin plate. Thus, the resin plate with a double-sided copper foil was produced. The thickness of the resin plate portion of the obtained resin plate with a double-sided copper foil was 0.3 mm.

### [Measurement and Evaluation Methods]

Measurement and evaluation were performed using the resin compositions obtained in Examples and Comparative Examples, the resin films, and the resin plates with a double-sided copper foil in accordance with the following methods. The results are shown in Table 1.

### (1. Method for Evaluating Flexibility of Resin Film)

The resin film (1) with a single-sided PET film obtained in each Example was wound around a cylinder with a diameter of 85 mm made of a resin at 25°C with the resin film surface facing outward. The appearance of the wound resin film was visually observed, and the flexibility of the resin film was evaluated in accordance with the following criteria.

### <Criteria of Flexibility>

A: Cracking of a resin film and peeling from a PET film were not observed.
B: Cracking of a resin film or peeling from a PET film was observed.

### (2. Method for Measuring and Evaluating Linear Expansion Coefficient and Glass Transition Temperature)

The resin plate with a double-sided copper foil obtained in each Examples was immersed in a solution of 10 mass% ammonium persulfate (available from MITSUBISHI GAS CHEMICAL COMPANY, INC.) that was a copper etchant, to remove the copper foil. The obtained resin plate was cut into 0.4 mm in width, 20 mm in length, and 0.2 mm in thickness and dried at 105°C for 1 hour, to obtain a test piece. Both ends in the long side direction of the test piece were vertically held by grasping tools such that the distance between the grasping tools was 10 mm. Subsequently, a dimensional change was measured using a thermomechanical analyzer (TMA) (trade name "SS6100" manufactured by Seiko Instruments Inc.) in a tensile mode at a temperature range of 30 to 300°C, a temperature increasing rate of 5°C/min, and a load of 4 g. The inflection point of the dimensional change with respect to the temperature as a glass transition temperature and the average value for dimensional change amount per unit temperature at 30 to 150°C as a linear expansion coefficient were evaluated in accordance with the following criteria. In the following criteria, A means excellent.

### <Criteria of Linear Expansion Coefficient>

A: less than 20 ppm/K
B: 20 ppm/K or more and less than 40 ppm/K
C: 40 ppm/K or more

### <Criteria of Glass Transition Temperature>

A: 180°C or more
B: less than 180°C

### (3. Method for Measuring and Evaluating Tensile Modulus of Elasticity at 25°C)

The resin plate with a double-sided copper foil obtained in each Examples was immersed in a solution of 10 mass% ammonium persulfate (available from MITSUBISHI GAS CHEMICAL COMPANY, INC.) that was a copper etchant, to remove the copper foil. The obtained resin plate was cut into 10 mm in width, 40 mm in length, and 0.2 mm in thickness and dried at 105°C for 1 hour, to obtain a test piece. Both ends in the long side direction of the test piece were vertically held by grasping tools such that the distance between the grasping tools was 20 mm. Subsequently, the tensile modulus of elasticity of the test piece was determined using a compact table-top universal tester (trade name "EZ-TEST" manufactured by Shimadzu Corporation) in an environment of 25°C under a condition of a tensile speed of 2 mm/min. Five test pieces were similarly produced, the tensile moduli of elasticity of the test pieces were determined under the same condition, and the average value of the tensile moduli of elasticity was obtained as a tensile modulus of elasticity at 25°C. Other detail conditions and calculation of the tensile modulus of elasticity followed international organization for standardization ISO5271(1993). The obtained tensile modulus of elasticity at 25°C was evaluated in accordance with the following criteria. In the following criteria, A means excellent.

### <Criteria of Tensile Modulus of Elasticity at 25°C>

A: less than 1.5 GPa
B: 1.5 GPa or more

### (4. Method for Measuring Peel Strength)

The copper foil of the resin plate with a double-sided copper foil obtained in each Example was processed into a straight line with a width of 5 mm by etching, and then dried at 105°C for 1 hour, to obtain a test piece. The straight line-shaped copper foil was attached with a compact table-top universal tester (trade name "EZ-TEST" manufactured by Shimadzu Corporation) and then peeled off in a direction of 90° in accordance with JIS C6481:1996. Thus, the peel strength of the copper foil was determined. The pulling rate when the copper foil was peeled off was 50 mm/min. The obtained peel strength was evaluated in accordance with the following criteria. In the following criteria, A means excellent.

### <Criteria of Peel Strength>

A: 0.5 kN/m or more
B: 0.4 kN/m or more and less than 0.5 kN/m

### (5. Method for Measuring and Evaluating Relative Dielectric Constant (Dk) and Dielectric Loss Tangent (Df))

The resin plate with a double-sided copper foil obtained in each Examples was immersed in a solution of 10 mass% ammonium persulfate (available from MITSUBISHI GAS CHEMICAL COMPANY, INC.) that was a copper etchant, to remove the copper foil. The obtained resin plate was cut into 2 mm × 50 mm and dried at 105°C for 1 hour, to obtain a test piece. The relative dielectric constant (Dk) and the dielectric loss tangent (Df) of the test piece were measured at an atmosphere temperature of 25°C in a 10 GHz zone in accordance with a cavity resonator perturbation method. The relative dielectric constant (Dk) and dielectric loss tangent (Df) of the cured product were evaluated in accordance with the following criteria. In the following criteria, A means excellent.

### <Criteria of Relative Dielectric Constant (Dk)>

A: less than 2.8
B 2.8 or more

### <Criteria of Dielectric Loss Tangent (Df)>

A: less than 0.0015
B: 0.0015 or more and less than 0.0025
C: 0.0025 or more and less than 0.0030

### (6. Thermal Conductivity)

The copper foil of the resin plate with a double-sided copper foil obtained in each Example was removed by etching, and then cut into 10 mm in length and 10 mm in width, to obtain a test piece. The test piece was blackened using a graphite spray, and the thermal diffusivity was evaluated using a xenon flash analyzer (trade name "LFA447 nanoflash" manufactured by NETZSCH). By multiplication of the thermal diffusivity, the density measured by an Archimedes method, and a specific heat measured using a differential scanning calorimetry (DSC; trade name "DSC Pyris1" manufactured by Perkin Elmer), the thermal conductivity of the test piece was determined. The obtained thermal conductivity was evaluated in accordance with the following criteria. In the following criteria, A means excellent.

### <Criteria of Thermal Conductivity>

A: 3.0 W/m·K or more
B: less than 3.0 W/m·K

### (7. 170°C Mass Reduction Rate)

From the resin film (1) with a single-sided PET film obtained in each Example, the PET film was peeled and removed, and the resin film was ground, to obtain a powder in a B-stage state as an evaluation sample. A 170°C mass reduction rate was the mass reduction rate during heating and drying at 170°C for 30 minutes in an air atmosphere using the evaluation sample: {(mass before heating - mass after heating at 170°C)/(mass before heating)}×100. The results are shown in Table 1. In Table 1, "≤1.0" represents that the 170°C mass reduction rate is 1.0 mass% or less.

**Table 1**

| | | | Example | | | | | | | | | | | | | | Comparative Example | | |
|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 1 | 2 | 3 |
| Component (A) | Maleimide resin A | | 6.2 | 6.2 | 6.2 | 6.2 | 6.2 | 6.2 | 6.2 | | | 3.1 | 9.3 | 3.1 | 9.3 | 1.7 | 12.4 | 19 | 3.4 |
| | Maleimide resin B | | | | | | | | | 6.2 | 6.2 | | | | | | | | |
| Component (B) | Bisphenol F type epoxy resin | | 6.2 | | | | | | | 6.2 | | 9.3 | 3.1 | | | | | | |
| | 1,9-nonanediol diacrylate | | | 6.2 | | | | | | | | | | | | | | | |
| | 1,10-decanediol diacrylate | | | | 6.2 | | | | | | | | | | | | | | |
| | Dioxane glycol diacrylate | | | | | 6.2 | | | | | | | | | | | | | |
| | 1,9-nonanediol dimethacrylate | | | | | | 6.2 | | 6.2 | | 6.2 | | | 9.3 | 3.1 | 1.7 | | | |
| | 1,12-dodecanediol dimethacrylate | | | | | | | 6.2 | | | | | | | | | | | |
| Component (C) | Silica | | 68.5 | 68.5 | 68.5 | 68.5 | 68.5 | 68.5 | 68.5 | 68.5 | 68.5 | 68.5 | 68.5 | 68.5 | 68.5 | | 68.5 | 52.3 | |
| | Alumina | | | | | | | | | | | | | | | 91.4 | | | 91.4 |
| Component (D) | Modified conjugated diene polymer | | 6.2 | 6.2 | 6.2 | 6.2 | 6.2 | 6.2 | | 6.2 | 6.2 | 6.2 | 6.2 | 6.2 | 6.2 | 1.7 | 6.2 | 9.5 | 1.7 |
| | Styrene-based elastomer | | 12.4 | 12.4 | 12.4 | 12.4 | 12.4 | 12.4 | 12.4 | 12.4 | 12.4 | 12.4 | 12.4 | 12.4 | 12.4 | 3.4 | 12.4 | 19.0 | 3.4 |
| | Conjugated diene polymer | | | | | | | | 6.2 | | | | | | | | | | |
| Component (E) | Organic peroxide | | 0.4 | 0.4 | 0.4 | 0.4 | 0.4 | 0.4 | 0.4 | 0.4 | 0.4 | 0.4 | 0.4 | 0.4 | 0.4 | 0.1 | 0.4 | 0.5 | 0.1 |
| | Imidazole-based curing accelerator | | 0.4 | 0.4 | 0.4 | 0.4 | 0.4 | 0.4 | 0.4 | 0.4 | 0.4 | 0.4 | 0.4 | 0.4 | 0.4 | 0.1 | 0.4 | 0.5 | 0.1 |
| Evaluation Results | Flexibility of resin film | | A | A | A | A | A | A | A | A | A | A | A | A | A | A | B | A | B |
| | Linear expansion coefficient | | A | A | A | A | A | A | A | A | A | A | A | A | A | A | A | C | A |
| | Glass transition temperature | | A | A | A | A | A | A | A | A | A | B | A | A | A | A | A | A | A |
| | Tensile modulus of elasticity at 25°C | | A | A | A | A | A | A | A | A | A | A | A | A | A | A | A | A | A |
| | Peel Strength | | A | A | A | A | A | A | A | A | A | A | A | A | A | B | A | A | B |
| | Dielectric properties (10 GHz) | Relative dielectric constant (Dk) | A | A | A | A | A | A | A | B | B | B | A | B | A | B | A | A | B |
| | | Dielectric loss tangent (Df) | C | B | B | A | A | A | A | C | A | D | B | B | A | A | A | A | A |
| | Thermal Conductivity | | B | B | B | B | B | B | B | B | B | B | B | B | B | A | B | B | A |
| | 170°C mass reduction rate (mass%) | | ≤1.0 | ≤1.0 | ≤1.0 | ≤1.0 | ≤1.0 | ≤1.0 | ≤1.0 | ≤1.0 | ≤1.0 | ≤1.0 | ≤1.0 | ≤1.0 | ≤1.0 | ≤1.0 | ≤1.0 | ≤1.0 | ≤1.0 |

Details of components listed in Table 1 are as follows.

### [(A) Component]

· Maleimide resin A: an aromatic bismaleimide resin containing an indan ring represented by the general formula (A1-4-1): number average molecular weight = 1,300, in a solid state at 25°C
· Maleimide resin B: trade name "MIR-3000" available from Nippon Kayaku Co., Ltd., a compound represented by the general formula (A2-7) in which X^{a14} is a divalent hydrocarbon group represented by the general formula (A2-8) in which X^{a15} and X^{a16} are a methylene group and Ar^{a1} is a 4,4'-biphenylene group: number average molecular weight = 500, in a solid state at 25°C

### [Component (B)]

· Bisphenol F type epoxy resin: epoxy group equivalent weight: 155 to 165 g/eq, in a liquid state at 25°C (viscosity at 25°C = 393 mPa s), number average molecular weight: 300
· 1,9-nonanediol diacrylate: in a liquid state at 25°C (viscosity at 25°C = 8 mPa s), molecular weight: 268.35
· 1,10-decanediol diacrylate: in a liquid state at 25°C (viscosity at 25°C = 12 mPa·s), molecular weight: 282.38
· Dioxane glycol diacrylate: acrylic acid 2-[5-ethyl-5-[(acryloyloxy)methyl]-1,3-dioxan-2-yl]-2,2-dimethylethyl, in a liquid state at 25°C (viscosity at 25°C = 310 mPa s), molecular weight: 326.38
· 1,9-nonanediol dimethacrylate: in a liquid state at 25°C (viscosity at 25°C = 8 mPa·s), molecular weight: 296.4
· 1,12-dodecanediol dimethacrylate: in a liquid state at 25°C (viscosity at 25°C = 11 mPa s), molecular weight: 338.5

### [Component (C)]

Silica: spherical silica treated with an amino silane coupling agent, average particle diameter: 0.5 µm
Alumina: a blend of alumina 1 (average particle diameter: 18 µm, polygonal spherical shape), alumina 2 (average particle diameter: 3 µm, polygonal spherical shape), and alumina 3 (average particle diameter: 0.4 µm, polygonal spherical shape) at a mass ratio of 66:24:10

### [Component (D)]

· Modified conjugated diene polymer: modified conjugated diene polymer obtained in Production Example 1, average molecular weight: 1,700
· Styrene-based elastomer: hydrogenated styrene-based thermoplastic elastomer (styrene-ethylene-butylene-styrene copolymer), trade name "Tuftec H1221", styrene unit content = 12 mass%, MFR under measurement condition of 230°C and a load of 2.16 kgf = 4.5 g/10 min, average molecular weight = 170,000
· Conjugated diene polymer: 1,2-polybutadiene homopolymer (number average molecular weight = 1,200, vinyl group content = 85% or more)

### [Component (E)]

· Organic peroxide: 1,3-di(t-butylperoxy isopropyl)benzene
· Imidazole-based curing accelerator: isocyanate-masked imidazole, trade name "G-8009L" available from DKS Co., Ltd.

The results show that the resin compositions obtained in Examples 1 to 14 of the embodiment are favorable in the low thermal expansibility of cured products, and the resin films formed from the resin compositions are excellent in flexibility. In the resin films in Examples 1 to 14, the 170°C mass reduction rate is 1.0 mass% or less. This shows that the generation of a volatile component during heating and curing is suppressed. On the other hand, the flexibility of the resin films in Comparative Examples 1 and 3 was inferior, and the low thermal expansibility of the resin composition in Comparative Example 2 was inferior.

### Industrial Applicability

The resin composition of the embodiment forms a cured product having favorable low thermal expansibility, has excellent flexibility in a solid state, and can suppress the generation of a component volatilized during heating and curing. Therefore, the resin composition of the embodiment is useful for a printed wiring board, a semiconductor package, and the like.

## Claims

1. A resin composition comprising:
(A) a thermosetting resin;
(B) a compound that is in a liquid state at 25°C, has a reactive group, and has a molecular weight of 1,000 or less; and
(C) an inorganic filler.

2. The resin composition according to claim 1, wherein the component (A) is one or more selected from the group consisting of a maleimide resin having one or more N-substituted maleimide groups and a derivative of the maleimide resin.

3. The resin composition according to claim 2, wherein the maleimide resin having one or more N-substituted maleimide groups is a maleimide resin containing a condensed ring of an aromatic ring and an aliphatic ring in a molecular structure and having two or more N-substituted maleimide groups.

4. The resin composition according to any one of claims 1 to 3, wherein the component (B) has as the reactive group one or more groups selected from a vinyl group, an allyl group, a maleimide group, a (meth)acryloyl group, an epoxy group, a hydroxy group, a carboxy group, and an amino group.

5. The resin composition according to any one of claims 1 to 3, wherein the number of the reactive group in the component (B) is two or more in one molecule.

6. The resin composition according to any one of claims 1 to 3, wherein the component (B) is a di(meth)acrylate.

7. The resin composition according to any one of claims 1 to 3, wherein a content of the component (B) relative to the total amount (100 mass%) of the components (A), (B), and (C) is 1 to 20 mass%.

8. The resin composition according to any one of claims 1 to 3, further comprising (D) an elastomer having a molecular weight of more than 1,000.

9. The resin composition according to any one of claims 1 to 3, the resin composition being used for formation of a resin film having a thickness of 80 µm or more.

10. A resin film comprising the resin composition according to any one of claims 1 to 3.

11. The resin film according to claim 10, the resin film having a thickness of 80 µm or more.

12. The resin film according to claim 10, wherein the resin film has a thickness of 150 µm or more, and a cured product of the resin film has a relative dielectric constant (Dk) at 10 GHz of less than 2.8 and a dielectric loss tangent (Df) of less than 0.0030.

13. The resin film according to claim 10, wherein a mass reduction rate during heating and drying at 170°C for 30 minutes in an air atmosphere is 2.0 mass% or less.

14. A printed wiring board comprising a cured product of the resin film according to claim 10.

15. A semiconductor package comprising a cured product of the resin film according to claim 10.

16. The semiconductor package according to claim 15, comprising a semiconductor chip sealed with the cured product of the resin film.
